# EUROPEAN PATENT APPLICATION

(11) **EP 4 836 626 A1**
(43) Date of publication of application: **04.11.2026**
(21) Application number: 26161535.5
(22) Date of filing: 02.03.2026
(51) Int. Cl.: H10B 43/40, H10B 41/42, H10B 43/27, H10B 43/50

(54) **SEMICONDUCTOR MEMORY DEVICE AND ELECTRONIC SYSTEM INCLUDING THE SAME**

(30) Priority: 09.04.2025 KR 20250046298
(71) Applicant: Samsung Electronics Co., Ltd., Suwon-si, Gyeonggi-do 16677 (KR)
(72) Inventor: LEE, Tae Gon, 16677 Suwon-si (KR); HONG, Seung Wan, 16677 Suwon-si (KR); KWON, Young Woo, 16677 Suwon-si (KR); KWON, O Jin, 16677 Suwon-si (KR); KIM, Woo Jae, 16677 Suwon-si (KR); PARK, Jung-Hwan, 16677 Suwon-si (KR); LEE, Min Jeong, 16677 Suwon-si (KR); LIM, Sun Young, 16677 Suwon-si (KR); CHA, Jae Hoon, 16677 Suwon-si (KR)
(74) Representative: Marks & Clerk LLP

(57) **Abstract**

Provided is a semiconductor memory device. The semiconductor memory device according to some embodiments of the present disclosure includes a substrate which extends in a first direction and a second direction that intersect one another, and includes a first region, and a second region spaced apart from the first region in the first direction around the first region, a gate stack structure which includes first insulating layers and gate electrode layers alternately stacked with one another, in the first region, a channel structure which penetrates the gate stack structure, a mold structure which includes first insulating layers and second insulating layers alternately stacked with one another and having different materials from one another in the second region, each of the second insulating layers extending from each of the gate electrode layers in a horizontal direction, a separation structure which separates the first region and the second region in the first direction, and extends in the second direction, and a first gate contact which penetrates at least a part of the mold structure, and is connected to a first gate electrode layer among the gate electrode layers.

## Description

### FIELD

The present disclosure relates to a semiconductor memory device and an electronic system including the same.

### BACKGROUND

It is required to increase the degree of integration of the semiconductor memory devices to satisfy excellent performance and low price required by consumers. In the case of the semiconductor memory device, because the degree of integration thereof is an important factor in determining the price of a product, an increased degree of integration is particularly required.

Meanwhile, in the case of a two-dimensional or planar semiconductor memory device, the degree of integration is mainly determined by an area occupied by unit memory cells, and is therefore greatly affected by the level of fine pattern forming technology. However, since ultra-expensive apparatuses are required to miniaturize the pattern, the degree of integration of the two-dimensional semiconductor device is increasing, but is still limited. Accordingly, three-dimensional semiconductor devices including memory cells arranged three-dimensionally have been proposed.

### SUMMARY

Aspects of the present disclosure provide a semiconductor memory device having improved electrical characteristics and reliability.

Aspects of the present disclosure also provide an electronic system including a semiconductor memory device having improved electrical characteristics and reliability.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

A semiconductor memory device according to some embodiments of the present disclosure includes a substrate which extends in a first direction and a second direction that intersect one another, and includes a first region, and a second region spaced apart from the first region in the first direction around the first region, a gate stack structure which includes first insulating layers and gate electrode layers alternately stacked with one another, in the first region, a channel structure which penetrates the gate stack structure, a mold structure which includes first insulating layers and second insulating layers alternately stacked with one another and having different materials from one another in the second region, each of the second insulating layers extending from each of the gate electrode layers in a horizontal direction, a separation structure which separates the first region and the second region in the first direction, and extends in the second direction, and a first gate contact which penetrates at least a part of the mold structure, and is connected to a first gate electrode layer among the gate electrode layers.

A semiconductor memory device according to some embodiments of the present disclosure includes a substrate which extends in a first direction and a second direction that intersect one another, and includes a first region, a second region, and a third region that are different from one another, the second region being spaced apart from the first region in the first direction, a gate stack structure which includes first insulating layers and gate electrode layers alternately stacked with one another in the first region, a channel structure which penetrates the gate stack structure, a bit line which is connected to the channel structure, and extends in the first direction, a dummy gate stack structure which includes second insulating layers and dummy gate electrode layers that are alternately stacked with one another, in the second region, a first dummy channel structure which penetrates the dummy gate stack structure, a separation structure which separates the first region and the second region in the first direction, and extends in the second direction between the channel structure and the first dummy channel structure, a mold structure which includes third insulating layers and fourth insulating layers alternately stacked with one another and having different materials from one another in the third region, and further includes a first pad portion that connects one of the third insulating layers and one of the gate electrode layers, and a first gate contact which penetrates at least a part of the mold structure and is connected to the first pad portion.

An electronic system according to some embodiments of the present disclosure includes a main board, a semiconductor memory device on the main board, and a controller electrically connected to the semiconductor memory device, on the main board, wherein the semiconductor memory device includes a substrate which extends in each of a first direction and a second direction that intersect one another, and includes a first region, a second region, and a third region that are different from one another, the second region being spaced apart from the first region in the first direction, a gate stack structure which includes first insulating layers and gate electrode layers alternately stacked with one another, in the first region, a channel structure which penetrates the gate stack structure, a dummy gate stack structure which includes second insulating layers and dummy gate electrode layers that are alternately stacked with one another, in the second region, a dummy channel structure which penetrates the dummy gate stack structure, a separation structure which separates the first region and the second region in the first direction, and extends in the second direction, a mold structure which includes third insulating layers and fourth insulating layers having different materials from one another and alternately stacked with one another, and a pad portion connected to one of the third insulating layers and one of the gate electrode layers, in the third region, and a gate contact which penetrates at least a part of the mold structure and is connected to the first pad portion.

A method for fabricating a semiconductor memory device according to some embodiments of the present disclosure includes providing a substrate which extends in each of a first direction and a second direction intersecting one another, and includes a first region and a second region, the second region being spaced apart from the first region in the first direction, forming a first pre-stack structure which includes first insulating layers and sacrificial layers alternately stacked with one another, on the substrate removing the sacrificial layers to form a second pre-stack structure which includes first insulating layers and gate electrode layers alternately stacked with one another, on the first region, forming a pre-mold structure which includes the first insulating layers and the second insulating layers alternately stacked with one another, on the second region, forming a separation structure which separates the first region and the second region in the first direction, and extends in the second direction, forming a gate contact hole which penetrates at least a part of the pre-mold structure, and forming a contact insulating layer and a sacrificial insulating layer inside the gate contact hole, removing the sacrificial insulating layer to form a first recess which exposes any one of the second insulating layers, forming a second recess in any one of the second insulating layers, using the first recess, and forming a contact conductive layer which fills the second recess.

Specific details of other embodiments are included in the detailed description and drawings.

At least some of the above and other features of the invention are set out in the claims.

### BRIEF DESCRIPTION OF DRAWINGS

The above and other aspects and features of the present disclosure will become more apparent by describing in detail illustrative embodiments thereof with reference to the attached drawings, in which:
FIG. 1 is an example block diagram for explaining a semiconductor memory device according to some embodiments;
FIG. 2 is an example circuit diagram of a semiconductor memory device according to some embodiments;
FIG. 3 is an example layout diagram for explaining a semiconductor memory device according to some embodiments;
FIG. 4 is an example layout diagram for explaining a memory cell block region and a dummy cell block region of the semiconductor memory device according to some embodiments;
FIG. 5 is an enlarged view of a region P1 of FIG. 4;
FIG. 6 is a cross-sectional view taken along A-A of FIG. 4;
FIG. 7 is an enlarged view of a region Q1 of FIG. 6;
FIG. 8 is an enlarged view of a region Q2 of FIG. 6;
FIG. 9 is a cross-sectional view taken along B-B of FIG. 4;
FIGS. 10 and 11 are example diagrams for explaining a capacitor structure of the semiconductor memory device according to some embodiments;
FIG. 12 is an example diagram for explaining a capacitor structure of the semiconductor memory device according to some embodiments;
FIGS. 13 to 22 are example diagrams for explaining a semiconductor memory device according to some embodiments;
FIGS. 23 and 24 are example cross-sectional views for explaining a semiconductor memory device according to some embodiments;
FIGS. 25 to 29 are intermediate diagrams for explaining a method for fabricating a semiconductor memory device according to some embodiments;
FIG. 30 is an example block diagram for explaining an electronic system according to some embodiments;
FIG. 31 is an example perspective view for explaining the electronic system according to some embodiments.

### DETAILED DESCRIPTION

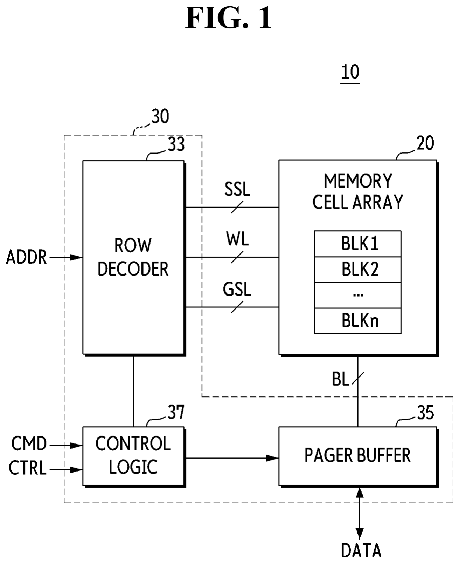

FIG. 1 is an example block diagram for explaining a semiconductor memory device according to some embodiments.

Referring to FIG. 1, a semiconductor memory device 10 according to some embodiments includes a memory cell array 20 and a peripheral circuit 30.

The memory cell array 20 may include a plurality of memory cell blocks BLK1 to BLKn. Each of the memory cell blocks BLK1 to BLKn may include a plurality of memory cells. The memory cell array 20 may be connected to the peripheral circuit 30 through bit lines BL, word lines WL, at least one string selection line SSL, and at least one ground selection line GSL. Specifically, the memory cell blocks BLK1 to BLKn may be connected to a row decoder 33 through the word lines WL, the string selection line SSL, and the ground selection line GSL. Further, the memory cell blocks BLK1 to BLKn may be connected to a page buffer 35 through the bit lines BL.

The peripheral circuit 30 may receive an address ADDR, a command CMD, and a control signal CTRL from the outside of the semiconductor memory device 10, and may transmit and receive data DATA to and from an external device of the semiconductor memory device 10. The peripheral circuit 30 may include a row decoder 33, a page buffer 35 and a control logic 37. The peripheral circuit 30 may further include various sub-circuits such as an input/output circuit, a voltage generation circuit that generates various voltages necessary for the operation of the semiconductor memory device 10, and an error correction circuit for correcting an error of the data DATA that is read from the memory cell array 20.

The control logic 37 may be connected to the row decoder 33, the page buffer 35, the input/output circuit, the voltage generation circuit, and the like. The control logic 37 may control the overall operation of the semiconductor memory device 10. The control logic 37 may generate various internal control signals used inside the semiconductor memory device 10 in response to the control signal CTRL. For example, the control logic 37 may adjust the voltage levels provided to the word lines WL and the bit lines BL when performing a memory operation such as a program operation or an erase operation.

The row decoder 33 may select at least one of the plurality of memory cell blocks BLK1 to BLKn in response to the address ADDR, and may select at least one word line WL, at least one string selection line SSL, and at least one ground selection line GSL of the selected memory cell blocks BLK1 to BLKn. The row decoder 33 may transmit a voltage for performing the memory operation to the word line WL of the selected memory cell blocks BLK1 to BLKn.

The page buffer 35 may be connected to the memory cell array 20 through the bit lines BL. The page buffer 35 may operate as a writer driver or a sense amplifier. Specifically, at the time of performing the program operation, the page buffer 35 may operate as the writer driver to apply a voltage according to the data DATA to be stored in the memory cell array 20 to the bit lines BL. On the other hand, at the time of performing the read operation, the page buffer 35 may operate as a sense amplifier to sense the data DATA stored in the memory cell array 20.

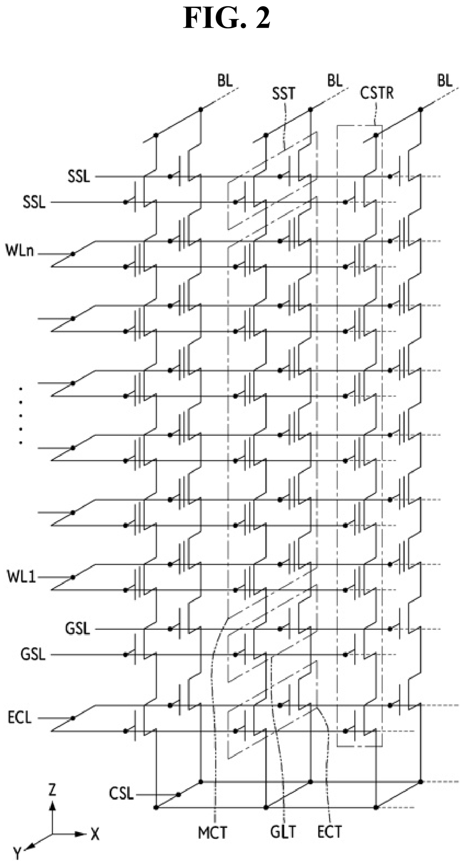

FIG. 2 is an example circuit diagram of a semiconductor memory device according to some embodiments.

Referring to FIG. 2, a memory cell array (e.g., 20 of FIG. 1) of the semiconductor memory device according to some embodiments may include a common source line CSL, a plurality of bit lines BL, and a plurality of cell strings CSTR.

The common source line CSL may extend in a first direction X. In some embodiments, a plurality of common source lines CSL may be arranged two-dimensionally. For example, the plurality of common source lines CSL may be spaced apart from one another and each extend in the first direction X. The same voltage may be electrically applied to the common source lines CSL, or different voltages may be applied to the common source lines CSL and the common source lines CSL may be controlled separately.

The plurality of bit lines BL may be arranged two-dimensionally. For example, the bit lines BL are spaced apart from one another, and may each extend in a second direction Y that intersects the first direction X. A plurality of cell strings CSTR may be connected in parallel to each bit line BL. The cell strings CSTR may be commonly connected to the common source line CSL. That is, the plurality of cell strings CSTR may be disposed between the bit lines BL and the common source line CSL.

Each cell string CSTR may include a ground selection transistor GLT connected to the common source line CSL, a string selection transistor SST connected to the bit line BL, and a plurality of memory cell transistors MCT disposed between the ground selection transistor GLT and the string selection transistor SST. Each memory cell transistor MCT may include a data storage element. The ground selection transistor GLT, the string selection transistor SST and the memory cell transistors MCT may be connected in series.

The common source line CSL may be commonly connected to sources of the ground selection transistors GLT. Also, the ground selection line GSL, a plurality of word lines WL1 to WLn, and the string selection line SSL may be disposed between the common source line CSL and the bit line BL. The ground selection line GSL may be used as a gate electrode of the ground selection transistor GLT, the word lines WL1 to WLn may be used as gate electrodes of the memory cell transistors MCT, and the string selection line SSL may be used as the gate electrode of the string selection transistor SST.

In some embodiments, an erasure control transistor ECT may be disposed between the common source line CSL and the ground selection transistor GLT. The common source line CSL may be commonly connected to the sources of the erasure control transistors ECT. Further, an erasure control line ECL may be disposed between the common source line CSL and the ground selection line GSL. The erasure control line ECL may be used as the gate electrode of the erasure control transistor ECT. The erasure control transistors ECT may generate a gate induced drain leakage (GIDL) to perform the erasure operation of the memory cell array.

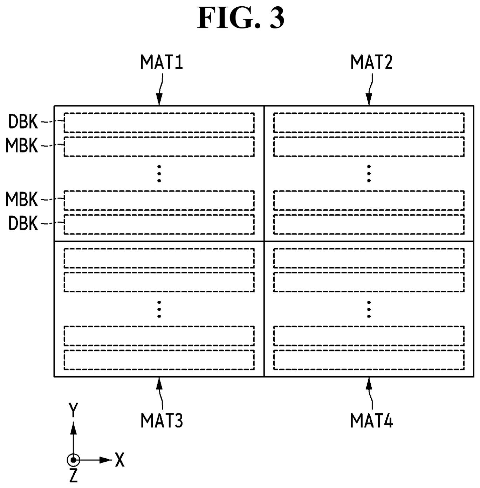

FIG. 3 is an example layout diagram for explaining a semiconductor memory device according to some embodiments.

Referring to FIG. 3, the semiconductor memory device according to some embodiments includes a plurality of mats MAT1, MAT2, MAT3, and MAT4. The plurality of mats MAT1, MAT2, MAT3, and MAT4 may be arranged in rows and columns along the first direction X and the second direction Y. The first direction X may be an extension direction of each of the word lines (WL of FIG. 1), and the second direction Y may be an extension direction of each of the bit lines (BL of FIG. 1). Each of the plurality of mats MAT1, MAT2, MAT3, and MAT4 may include a plurality of memory cells.

Each of the plurality of mats MAT1, MAT2, MAT3, and MAT4 may include at least one memory cell block MBK, and at least one dummy cell block DBK disposed in the periphery of the memory cell block MBK. The dummy cell block DBK may be disposed in the outermost region in each of the plurality of mats MAT1, MAT2, MAT3, and MAT4. In the single mat MAT1, the dummy cell block DBK may be disposed at both ends of the single mat MAT1 compared to the memory cell block MBK. In the single mat MAT1, the memory cell blocks MBK may be disposed inside the dummy cell block DBK. Inside the single mat MAT1, the dummy cell block DBK may be spaced apart from the memory cell blocks MBK in the second direction Y.

A third mat MAT3 may be adjacent to the first mat MAT1 in the second direction Y. The dummy cell block DBK of the first mat MAT1 closest to the third mat MAT3 may be spaced apart from the dummy cell block DBK of the third mat MAT3 closest to the first mat MAT1 in the second direction Y. The second mat MAT2 may be adjacent to the first mat MAT1 in the first direction X. The dummy cell block DBK of the first mat MAT1 closest to the second mat MAT2 may be spaced apart from the dummy cell block DBK of the second mat MAT2 closest to the first mat MAT1 in the first direction X. However, the embodiment is not limited thereto, and the dummy cell block DBK of the first mat MAT1 closest to the second mat MAT2 may be connected to the dummy cell block DBK of the second mat MAT2 closest to the first mat MAT1.

Although FIG. 3 shows that only four mats are arranged in a 2×2 format in the first and second directions X and Y, the number and arrangement form of the mats are not limited thereto. For example, the number of mats may be, but is not limited to, six in addition to four, or may be eight. Furthermore, the plurality of mats may be arranged in a 1×4 format or a 4×1 format, but the technical idea of the present disclosure is not limited thereto.

The plurality of memory cells of the plurality of mats MAT1, MAT2, MAT3, and MAT4 may be electrically connected to a peripheral circuit (30 of FIG. 1). Although not specifically shown, the peripheral circuit (30 of FIG. 1) may be disposed to be spaced apart from the plurality of mats MAT1, MAT2, MAT3, and MAT4 in the second direction Y. The peripheral circuit (30 of FIG. 1) may be disposed to be adjacent to the plurality of mats MAT1, MAT2, MAT3, and MAT4 in the second direction Y. However, the position of the peripheral circuit (30 of FIG. 1) is not limited thereto, and the peripheral circuit (30 of FIG. 1) may be disposed above and/or below the plurality of mats MAT1, MAT2, MAT3, and MAT4 in the third direction Z.

Storage, erasure, and/or read operations of data may be performed in the memory cell block MBK. The storage, erasure, and/or read operations of data may not be performed in the dummy cell block DBK.

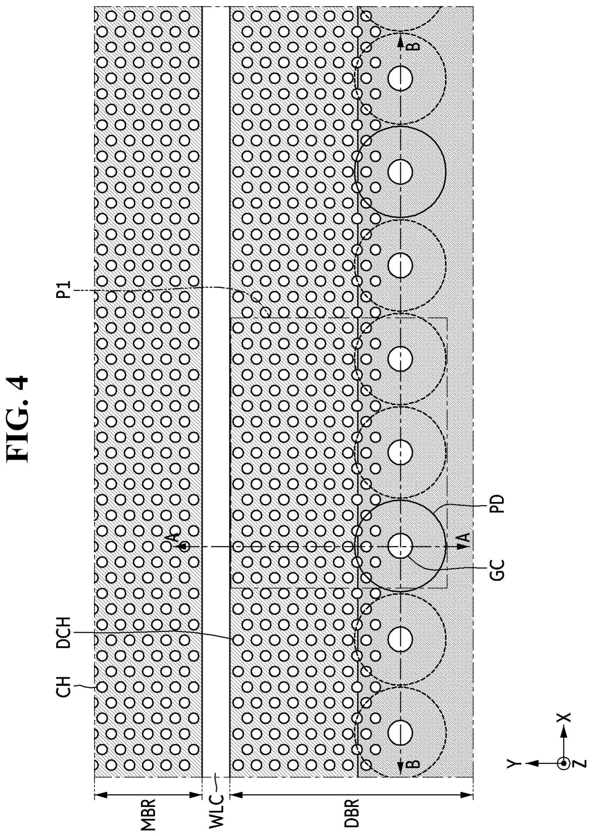

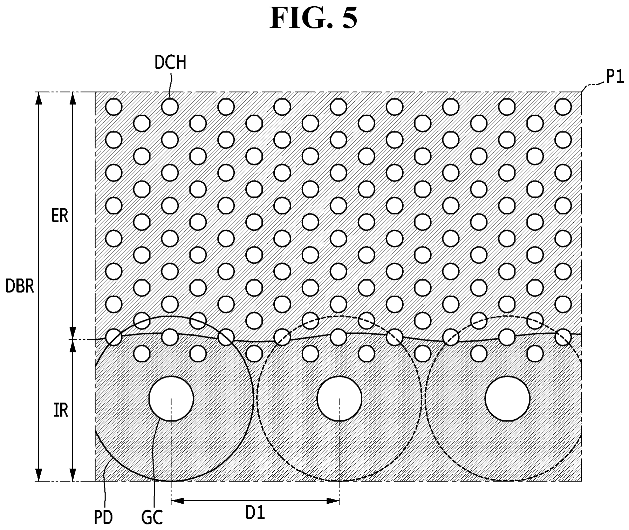

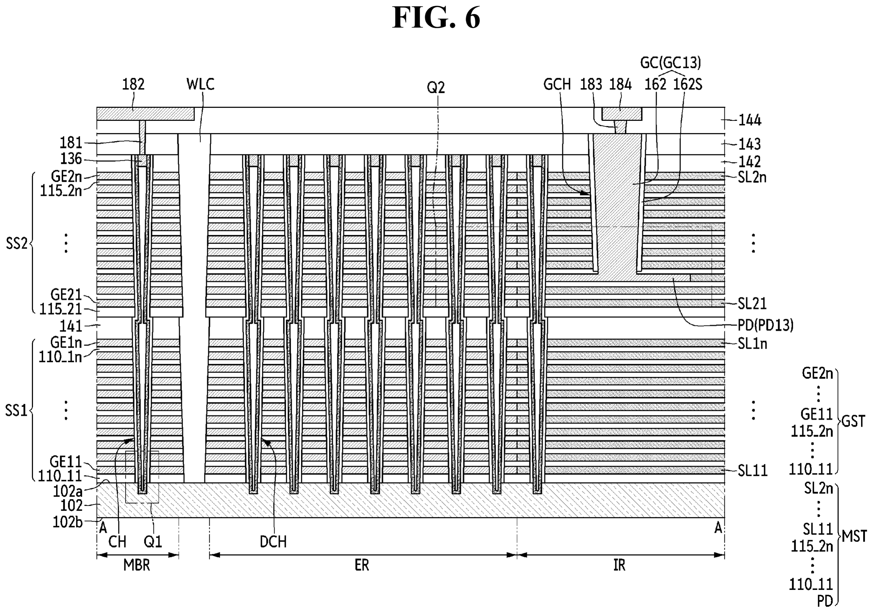

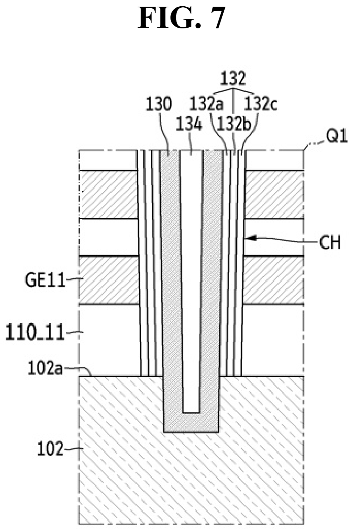

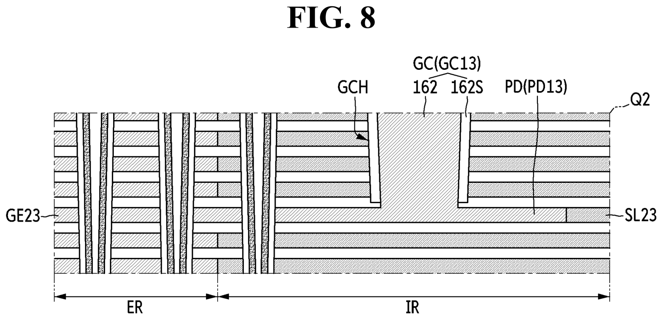

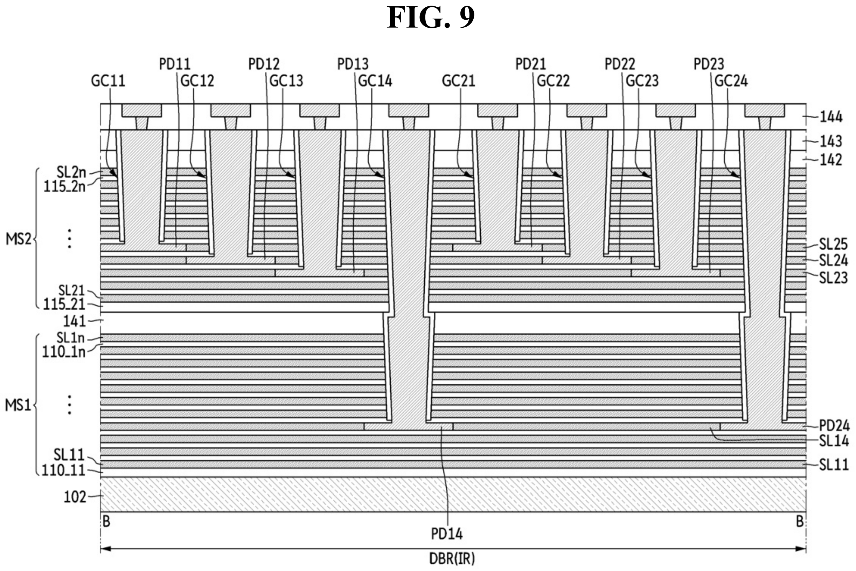

FIG. 4 is an example layout diagram for explaining a memory cell block region and a dummy cell block region of the semiconductor memory device according to some embodiments. FIG. 5 is an enlarged view of a region P1 of FIG. 4. FIG. 6 is a cross-sectional view taken along A-A of FIG. 4. FIG. 7 is an enlarged view of a region Q1 of FIG. 6. FIG. 8 is an enlarged view of a region Q2 of FIG. 6. FIG. 9 is a cross-sectional view taken along B-B of FIG. 4.

The semiconductor memory device according to some embodiments may include a substrate 102, a gate stack structure GST, a mold structure MST, a channel structure CH, a dummy channel structure DCH, a separation structure WLC, and a gate contact GC.

The substrate 102 may include a memory cell block region MBR, and a dummy cell block region DBR around the memory cell block region MBR. The memory cell block region MBR may correspond to a memory cell block MBK inside one mat (e.g., MAT1) in FIG. 3, and the dummy cell block region DBR may correspond to a dummy cell block DBK spaced apart from the memory cell block MBK in the second direction Y inside the one mat (e.g., MAT1). The dummy cell block region DBR may include an electrode region ER and a mold region IR. The electrode region ER may be disposed between the memory cell block region MBR and the mold region IR. The memory cell block region MBR, the electrode region ER, and the mold region IR may refer to different regions on the substrate 102.

The substrate 102 may include a semiconductor substrate such as a silicon substrate, a germanium substrate, or a silicon-germanium substrate. Alternatively, the substrate 102 may include a silicon-on-insulator (SOI) substrate, a germanium-on-insulator (GOI) substrate, or the like. In some embodiments, the substrate 102 may include polysilicon (poly Si).

The substrate 102 may include a first side 102a and a second side 102b that are opposite to one another. In the following description, the first side 102a may also be referred to as a front side, and the second side 102b may also be referred to as a back side. The first side 102a of the substrate 102 may extend in each of the first direction X and the second direction Y that intersect one another. Each of the first direction X and the second direction Y may refer to a horizontal direction aligned with the first side 102a. The first direction X and the second direction Y may be directions that intersect perpendicularly with one another. A third direction Z may be a height direction that is perpendicular to each of the first direction X and the second direction Y.

In some embodiments, the substrate 102 may include a conductive material, for example, polysilicon doped with impurities, a metal or a metal silicide, etc. As an example, the substrate 102 may include polysilicon (poly-Si) doped with N-type impurities (e.g., phosphorus (P) or arsenic (As)). Such a substrate 102 may be provided as a common source line of a semiconductor memory device according to some embodiments.

The gate stack structure GST may be disposed in the memory cell block region MBR and the electrode region ER. The gate stack structure GST may include first insulating layers 110_11...110_1n and second insulating layers 115_21...115_2n and gate electrodes GE11...GE1n and GE21...GE2n (e.g. gate electrode layers) that are stacked alternately with one another.

The gate stack structure GST may include a first stack structure SS1 and a second stack structure SS2. The first stack structure SS1 and the second stack structure SS2 may be sequentially stacked on the first side 102a of the substrate 102.

The first stack structure SS1 may include a plurality of first insulating layers 110_11...110_1n and a plurality of first gate electrodes GE11...GE1n that are alternately stacked along the third direction Z. Each of the first insulating layers 110_11...110_1n and each of the first gate electrodes GE11...GE1n may have a layered structure extending along a horizontal plane (e.g., an XY plane). The first gate electrodes GE11...GE1n are spaced apart from one another by the first insulating films 110_11...110_1n, and may be sequentially stacked.

In some embodiments, the first gate electrodes GE11...GE1n may include at least one ground selection line (e.g., GSL of FIG. 1) and a plurality of word lines (e.g., a part of WL of FIG. 1) that are stacked on the substrate 102. Although not shown, the first gate electrodes GE11...GE1n may further include at least one erasure control line. The number and thickness of the first insulating layers 110_11...110_1n and the first gate electrodes GE11...GE1n are merely an example, and are not limited to those shown in the drawings.

A first interlayer insulating film 141 may cover the first stack structure SS1 and a first mold structure MS1 to be described below. The first interlayer insulating film 141 may include, but is not limited to, at least one of silicon oxide, silicon oxynitride, and/or a low-dielectric constant (low-k) material having a dielectric constant smaller than that of silicon oxide.

The second stack structure SS2 may include a plurality of second insulating films 115_21...115_2n and a plurality of second gate electrodes GE21...GE2n that are alternately stacked along the third direction Z. Each of the second insulating films 115_21...115_2n and each of the second gate electrodes GE21...GE2n may have a layered structure extending along the horizontal plane (e.g., the XY plane). The second gate electrodes GE21...GE2n are spaced apart from one another by the second insulating films 115_21...115_2n, and may be sequentially stacked.

In some embodiments, the second gate electrodes GE21...GE2n may include word lines (e.g., a part of WL of FIG. 1) and at least one string selection line (e.g., SSL of FIG. 1) that are sequentially stacked on the first stack structure SS1. The number and thickness of the second insulating films 115_21...115_2n and the second gate electrodes GE21...GE2n are merely examples, and are not limited to those shown in the drawings.

A second interlayer insulating film 142 may cover the second stack structure SS2 and a second mold structure MS2 to be described below. The second interlayer insulating film 142 may include, but is not limited to, at least one of silicon oxide, silicon oxynitride, and/or a low-dielectric constant (low-k) material having a dielectric constant smaller than that of silicon oxide.

Each of the gate electrodes GE11...GE1n and GE21...GE2n may include, but is not limited to, a conductive material, for example, a metal such as tungsten (W), molybdenum (Mo), ruthenium (Ru), cobalt (Co) and nickel (Ni), or a semiconductor material such as silicon. In some embodiments, each of the gate electrodes GE11...GE1n and GE21...GE2n may include a metal film. As an example, each of the gate electrodes GE11...GE1n and GE21...GE2n may include at least one of a tungsten (W) film, a molybdenum (Mo) film, and/or a ruthenium (Ru) film.

Each of the insulating layers 110_11...110_1n and 115_21...115_2n may include, but is not limited to, at least one of a silicon oxide, a silicon nitride, and/or a silicon oxynitride. As an example, each of the insulating layers 110_11...110_1n and 115_21...115_2n may include a silicon oxide film.

A channel structure CH may be formed on the substrate 102 of each memory cell block region MBR. The channel structure CH may extend in the third direction Z, and penetrate at least a part of the stack structures SS1 and SS2. The channel structure CH may intersect a plurality of gate electrodes GE11...GE1n and GE21...GE2n. For example, the channel structure CH may be a pillar (e.g., cylindrical) structure extending in the third direction Z.

In some embodiments, a plurality of channel structures CH may be arranged in a zigzag shape. For example, as shown in FIGS. 4 and 5, the channel structures CH may be arranged alternately with one another in the first direction X and the second direction Y. Such channel structures CH may further improve the degree of integration of the semiconductor memory device. The number, arrangement and the like of the channel structures CH are merely examples, and are not limited to those shown in the drawings.

Each channel structure CH may include a semiconductor film 130 and a data storage film 132.

The semiconductor film 130 extends in the third direction Z, and may intersect the plurality of gate electrodes GE11...GE1n and GE21...GE2n. Although the semiconductor film 130 is shown only as being a cup-like shape, this is merely an example. For example, the semiconductor film 130 may have various shapes, such as a cylindrical shape, a rectangular barrel shape, and a solid filler shape. The semiconductor film 130 may include, for example, but is not limited to, a semiconductor material such as single crystal silicon, polycrystalline silicon, organic semiconductor substance and carbon nanostructure

In some embodiments, the semiconductor film 130 may be electrically connected to the substrate 102. For example, one end (e.g., a lower end) of the semiconductor film 130 may be in contact with the substrate 102.

In some embodiments, the semiconductor film 130 may protrude beyond the first stack structure SS1 and the data storage film 132. For example, one end (e.g., a lower end) of the semiconductor film 130 may be formed to be lower than a lower side of the first stack structure SS1 and a lower side of the data storage film 132. The substrate 102 may be in contact with one end (e.g., the lower end) of the semiconductor film 130 that protrudes beyond the first stack structure SS1 and the data storage film 132.

The data storage film 132 may be interposed between the semiconductor film 130 and the plurality of gate electrodes GE11...GE1 and GE21...GE2n. For example, the data storage film 132 may extend along the outer side of the semiconductor film 130. The data storage film 132 may include, for example, but is not limited to, at least one of silicon oxide, silicon nitride, silicon oxynitride, and a high-dielectric constant material having a higher dielectric constant than silicon oxide. The high-dielectric constant material may include, for example, at least one of aluminum oxide, hafnium oxide, lanthanum oxide, tantalum oxide, titanium oxide, lanthanum hafnium oxide, lanthanum aluminum oxide, dysprosium scandium oxide, and combinations thereof..

In some embodiments, as shown in FIG. 7, the data storage film 132 may include a tunnel insulating film 132a, a charge storage film 132b, and a blocking insulating film 132c, which are sequentially stacked on the outer side of the semiconductor film 130.

The tunnel insulating film 132a may include, for example, silicon oxide or a high-dielectric constant material having a higher dielectric constant than silicon oxide (e.g., aluminum oxide (Al₂O₃), and hafnium oxide (HfO₂)). The charge storage film 132b may include, for example, silicon nitride. The blocking insulating film 132c may include, for example, silicon oxide or a high-dielectric constant material having a higher dielectric constant than silicon oxide (e.g., aluminum oxide (Al₂O₃), and hafnium oxide (HfO₂)).

In some embodiments, each channel structure CH may further include a filling insulating film 134. The filling insulating film 134 may be formed to fill the inside of the cup-shaped semiconductor film 130. The filling insulating film 134 may include, for example, but is not limited to, at least one of silicon oxide, silicon nitride, and/or silicon oxynitride.

In some embodiments, each of the channel structures CH may further include a channel pad 136. The channel pad 136 may be formed to be connected to the other end (e.g., the upper end) of the semiconductor film 130. The channel pad 136 may include a conductive material, for example, polysilicon doped with impurities, a metal, a metal silicide or the like. As an example, the channel pad 136 may include polysilicon (poly-Si) doped with N-type impurities (e.g., phosphorus (P) or arsenic (As)).

The separation structure WLC may cut the stack structures SS1 and SS2. For example, as shown in FIG. 6, the uppermost side of the separation structure WLC may be formed to be the same as or higher than the upper side of the second stack structure SS2, and the lowermost side of the separation structure WLC may be formed to be the same as or lower than the lower side of the first stack structure SS1.

The separation structure WLC may extend long in the first direction X. Although not shown, a plurality of separation structures WLC may be spaced apart from one another and arranged along the second direction Y. The stack structures SS1 and SS2 may be divided by a plurality of separation structures WLC to form a plurality of memory cell blocks (e.g., BLK1 to BLKn of FIG. 1). The separation structure WLC may be disposed between the memory cell block region MBR and the dummy cell block region DBR. The separation structure WLC may be disposed between the channel structure CH and a dummy channel structure DCH to be described below. The separation structure WLC may be disposed between the channel structure CH and a gate contact GC to be described below.

In some embodiments, the separation structure WLC may include an insulating material, for example, at least one of silicon oxide, silicon nitride, and/or silicon oxynitride. As an example, the separation structure WLC may include a silicon oxide film.

The plurality of dummy channel structures DCH each extend in the third direction Z and may penetrate the second interlayer insulating film 142 and the stack structures SS1 and SS2. The dummy channel structure DCH does not function as a channel of a transistor, unlike the channel structure CH. The dummy channel structures DCH are not electrically connected to a first conductive line 182 and gate electrodes GE11...GE1n and GE21...GE2n, which will be described below. The dummy channel structures DCH may be formed in a shape similar to the channel structure CH. The dummy channel structures DCH may include the same film as the channel structure CH.

The mold structure MST may be disposed in the mold region IR of the dummy cell block region DBR. The mold structure MST may include first and second insulating layers 110_11...110_1n and 115_21...115_2n and third insulating layers SL11...SL1 and SL21...SL2n which are alternately stacked along the third direction Z.

The mold structure MST may include a first mold structure MS1 and a second mold structure MS2. The first mold structure MS1 and the second mold structure MS2 may be stacked sequentially on the first side 102a of the substrate 102.

The first mold structure MS1 may include a plurality of first insulating layers 110_11...110_1n and a plurality of third_1 insulating layers SL11...SL1n that are alternately stacked along the third direction Z. Each of the first insulating layers 110_11...110_1n and each of the plurality of third_1 insulating layers SL11...SL1n may have a layered structure extending along the horizontal plane (e.g., the XY plane). The plurality of third_1 insulating layers SL11...SL1n are spaced apart from one another by the first insulating layers 110_11...110_1n, and may be sequentially stacked.

The second mold structure MS2 may include a plurality of second insulating layers 115_21...115_2n and a plurality of third_2 insulating layers SL21...SL2n that are alternately stacked along the third direction Z. Each of the second insulating layers 115_21...115_2n and each of the third_2 insulating layers SL21... SL2n may have a layered structure extending along the horizontal plane (e.g., the XY plane). The third_2 insulating layers SL21...SL2n may be spaced apart from one another by the second insulating layers 115_21...115_2n, and sequentially stacked.

Each of the third insulating layers SL11...SL1n and SL21...SL2n may include, for example, but is not limited to, at least one of silicon oxide, silicon nitride, and/or silicon oxynitride. The third insulating layers SL11...SL1 and SL21...SL2n may have a different material from the first and second insulating layers 110_11...110_1n and 115_21...115_2n. For example, the third insulating layers SL11...SL1n and SL21...SL2n may include a material having etching selectivity with respect to the first and second insulating layers 110_11...110_1n and 115_21...115_2n. As an example, each of the third insulating layers SL11...SL1n and SL21...SL2n may include silicon nitride.

The gate contacts GC may be formed on the substrate 102 of the mold region IR. The plurality of gate contacts GC may be connected to each of the corresponding plurality of gate electrodes GE11...GE1 and GE21...GE2n. For example, each gate contact GC may extend in the third direction Z, and be connected to a corresponding one of the gate electrodes GE11...GE1n and GE21...GE2n. Each gate contact GC may penetrate at least a part of the mold structures MS1 and MS2, and be connected to a corresponding one (hereinafter, a selection gate electrode) of the gate electrodes GE11...GE1n and GE21...GE2n.

The plurality of gate contacts GC may be formed inside each gate contact hole GCH extending into the mold structure MS1 and MS2. Each gate contact GC may include a contact insulating layer 162S and a contact conductive layer 162 inside the gate contact hole GCH. Referring to FIG. 5, from a planar viewpoint, the gate contacts GC may have a first pitch D1. A pitch between the gate contacts GC is not limited thereto, and may be various as described below.

The contact conductive layer 162 of the first gate contact GC (e.g., GC13) may fill at least a part of each gate contact hole GCH. The contact conductive layer 162 may come into contact with the first pad portion PD (e.g., PD13), a part of which is exposed by the gate contact hole GCH.

An entire lower side of the contact conductive layer 162 may come into contact with the first pad portion PD (e.g., PD13). A width of the first pad portion PD (e.g., PD13) may be greater than a width of the first gate contact GC (e.g., GC13).

The contact conductive layer 162 may include a conductive material. The contact conductive layer 162 may include, for example, at least one of tungsten (W), copper (Cu), aluminum (Al), and alloys thereof. The corresponding one (selection gate electrode) of the gate electrodes GE11...GE1n and GE21...GE2n may include a conductive material different from the contact conductive layer 162. For example, when the corresponding one (selection gate electrode) of the gate electrodes GE11...GEln and GE21...GE2n includes molybdenum (Mo), the contact conductive layer 162 may include tungsten (W). However, the technical idea of the present disclosure is not limited thereto, and corresponding one (selection gate electrode) of the gate electrodes GE11...GEln and GE21...GE2n and the contact conductive layer 162 may include the same conductive material.

The contact insulating layer 162S may surround the side faces of each contact conductive layer 162. The contact insulating layer 162S may conformally extend along the side wall of each contact conductive layer 162. The contact insulating layer 162S does not cover the first pad portion PD (e.g., PD13), a part of which is exposed by each gate contact hole GCH. The contact insulating layer 162S may include an insulating material. The contact insulating layer 162S may include, for example, but is not limited to, silicon oxide.

Each of the third insulating layers SL11...SL1n and SL21...SL2n may extend in the second direction Y from each of the corresponding gate electrodes GE11...GE1n and GE21...GE2n. Any one of the third insulating layers SL11...SL1n and SL21...SL2n may be connected to a corresponding one of the gate electrodes GE11...GE1n and GE21...GE2n through the first pad portion PD (e.g., PD13). Any one (e.g., SL23 of FIG. 8) of the third insulating layers SL11...SL1n and SL21...SL2n may be connected to the corresponding one (e.g., GE23 of FIG. 8) of the gate electrodes GE11...GE1n and GE21...GE2n through the first pad portion PD (e.g., PD1). The first pad portion PD (e.g., PD13) is disposed between any one (e.g., SL23 of FIG. 8) of the third insulating layers SL11...SL1n and SL21...SL2n and a corresponding one (e.g., GE23 of FIG. 8) of the gate electrodes GE11...GE1n and GE21...GE2n, and connect them. The first pad portion PD (e.g., PD13) may be located at the same vertical level as each of any one (e.g., SL23 of FIG. 8) of the third insulating layers SL11...SL1n and SL21...SL2n and the corresponding one (e.g., GE23 of FIG. 8) of the gate electrodes GE11...GE1n and GE21...GE2n.

In some embodiments, the pad portion PD may connect the memory cell block region MBR and the dummy cell block region DBR, and prevent the collapse of the dummy cell block region DBR.

The second gate contact GC23 penetrates at least a part of the mold structures MS1 and MS2, and may be connected to the corresponding one (e.g., GE23 of FIG. 8) of the gate electrodes GE11...GE1n and GE21...GE2n. The second gate contact GC23 may be located at the same vertical level as the first gate contact GC13. The second gate contact GC23 may be connected to a second pad portion PD23.

The second pad portion PD23 may connect any one (e.g., SL23 of FIG. 8) of the third insulating layers SL11...SL1n and SL21...SL2n to a corresponding one (e.g., GE23 of FIG. 8) of the gate electrodes GE11...GE1n and GE21...GE2n. The second pad portion PD23 may be spaced apart from the first pad portion PD13 in the first direction X. The second pad portion PD23 may be located at the same vertical level as the first pad portion PD13.

The description of the first gate contact GC13 described above may be similarly applied to the structure and material of the second gate contact GC23. The description of the first pad portion PD13 described above may be similarly applied to the structure and material of the second pad portion PD23.

That is, the plurality of gate contacts GC may be connected to one of the gate electrodes GE11...GE1n and GE21...GE2n. The plurality of pad portions PD may be connected to one of the gate electrodes GE11...GE1n and GE21...GE2n. In some embodiments, as the plurality of gate contacts GC are connected to one gate electrode, the resistance characteristics may be improved.

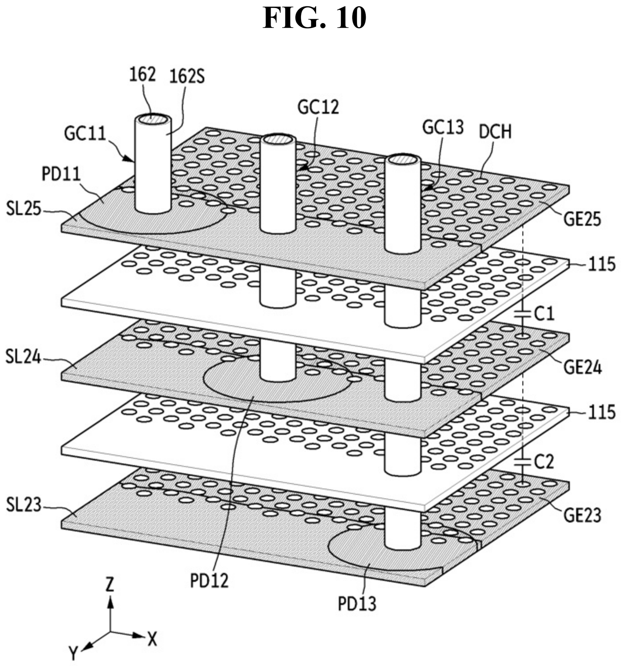

A third gate contact GC11 and a fourth gate contact GC21 penetrate at least a part of the mold structures MS1 and MS2, and may be connected to a corresponding one (GE25 of FIG. 10) of the gate electrodes GE11...GE1n and GE21...GE2n. The third gate contact GC11 may be located at the same vertical level as the fourth gate contact GC21. Each of the third gate contact GC11 and the fourth gate contact GC21 may be connected to the third pad portion PD11 and the fourth pad portion PD21.

The third pad portion PD11 and the fourth pad portion PD21 may connect one insulating layer SL25 of the third insulating layers SL11...SL1n and SL21...SL2n to a corresponding one gate electrode (GE25 of FIG. 10) of the gate electrodes GE11...GE1n and GE21...GE2n. The third pad portion PD11 may be spaced apart from the fourth pad portion PD21 in the first direction X. The third pad portion PD11 may be located at the same vertical level as the fourth pad portion PD21.

The description of the first gate contact GC13 and the second gate contact GC23 described above may be similarly applied to the structures and materials of the third gate contact GC11 and the fourth gate contact GC21. The description of the first pad portion PD13 and the second pad portion PD23 may be similarly applied to the structures and materials of the third pad portion PD11 and the fourth pad portion PD21.

A fifth gate contact GC12 and a sixth gate contact GC22 penetrate at least a part of the mold structures MS1 and MS2, and may be connected to a corresponding one (GE24 of FIG. 10) of the gate electrodes GE11...GE1n and GE21...GE2n. The fifth gate contact GC12 may be located at the same vertical level as the sixth gate contact GC22. Each of the fifth gate contact GC12 and the sixth gate contact GC22 may be connected to the fifth pad portion PD12 and the sixth pad portion PD22.

The fifth pad portion PD12 and the sixth pad portion PD22 may connect one insulating layer (e.g., SL24) of the third insulating layers SL11...SL1n and SL21...SL2n to corresponding one gate electrode (GE24 of FIG. 10) of the gate electrodes GE11...GE1n and GE21...GE2n. The fifth pad portion PD12 may be spaced apart from the sixth pad portion PD22 in the first direction X. The fifth pad portion PD12 may be located at the same vertical level as the sixth pad portion PD22.

The description of the first gate contact GC13 and the second gate contact GC23 described above may be similarly applied to the structures and materials of the fifth gate contact GC12 and the sixth gate contact GC22. The description of the first pad portion PD13 and the second pad portion PD23 described above may be similarly applied to the structures and materials of the fifth pad portion PD12 and the sixth pad portion PD22.

A seventh gate contact GC14 and an eighth gate contact GC24 penetrate at least a part of the mold structures MS1 and MS2, and may be connected to the corresponding one of the gate electrodes GE11...GE1n and GE21...GE2n. The seventh gate contact GC14 may be located at the same vertical level as the eighth gate contact GC24. Each of the seventh gate contact GC14 and the eighth gate contact GC24 may be connected to the seventh pad portion PD14 and the eighth pad portion PD24.

The seventh pad portion PD14 and the eighth pad portion PD24 may connect one insulating layer (e.g., SL14) of the third insulating layers SL11...SL1n and SL21...SL2n to the corresponding one gate electrode of the gate electrodes GE11...GE1n and GE21...GE2n. The seventh pad portion PD14 may be spaced apart from the eighth pad portion PD24 in the first direction X. The seventh pad portion PD14 may be located at the same vertical level as the eighth pad portion PD24.

The description of the first gate contact GC13 and the second gate contact GC23 described above may be similarly applied to the structures and materials of the seventh gate contact GC14 and the eighth gate contact GC24. The description of the first pad portion PD13 and the second pad portion PD23 described above may be similarly applied to the structures and materials of the seventh pad portion PD14 and the eighth pad portion PD24.

Although FIG. 9 only shows that the third pad portion PD11, the fifth pad portion PD12, and the first pad portion PD13 are located at a sequential vertical level in the third direction Z, the embodiment is not limited thereto. The vertical levels of the third pad portion PD11, the fifth pad portion PD12, the first pad portion PD13, and the seventh pad portion PD14 are not limited to those shown in the drawing.

In some embodiments, each gate contact GC may penetrate the second interlayer insulating film 142. For example, the third interlayer insulating film 143 may be formed on the second interlayer insulating film 142. Each gate contact GC penetrates at least a part of the third interlayer insulating film 143, the second interlayer insulating film 142, and the mold structures MS1 and MS2, and may be connected to the selection gate electrode.

In some embodiments, the width of each gate contact GC may decrease toward the substrate 102. This may be due to the fact that the etching process for forming the gate contact GC is performed in a direction from the mold structures MS1 and MS2 toward the substrate 102.

A first contact pattern 181, a first conductive line 182, a second contact pattern 183, and a second conductive line 184 may be disposed inside the third and fourth interlayer insulating films 143 and 144.

The first contact pattern 181 may be formed on the channel structure CH. The first contact pattern 181 may connect the channel pad 136 and the first conductive line 182. The first conductive line 182 may be electrically connected to the channel structure CH through the first contact pattern 181.

The first conductive lines 182 may extend long in the second direction Y in the memory cell block region MBR. Although not shown, the first conductive lines 182 may be spaced apart from one another in the first direction X, and extend side by side in the second direction Y. The first conductive lines 182 may be electrically connected to the channel structures CH arranged along the second direction Y. The first conductive lines 182 may be provided as bit lines (BL of FIG. 1).

The second contact pattern 183 may be formed on the gate contact GC. The second contact pattern 183 may connect the gate contact GC and the second conductive line 184.

The second conductive line 184 may extend long in the second direction Y in the mold region IR. Although not shown, the second conductive lines 184 are spaced apart from one another in the first direction X, and may extend side by side in the second direction Y. The second conductive lines 184 may be electrically connected to the gate contacts GC arranged along the second direction Y.

Each of the first contact pattern 181, the first conductive line 182, the second contact pattern 183, and the second conductive line 184 may include a conductive material, for example, but is not limited to, at least one of aluminum (Al), copper (Cu), tungsten (W), molybdenum (Mo), cobalt (Co), ruthenium (Ru), and alloys thereof.

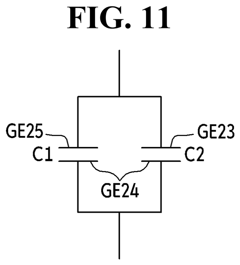

FIGS. 10 and 11 are example diagrams for explaining a capacitor structure of the semiconductor memory device according to some embodiments. For convenience of explanation, repeated parts of contents explained above using FIGS. 1 to 9 will be briefly explained or omitted.

FIG. 11 shows the capacitor structure formed by some gate electrodes GE25, GE24, and GE23 among the gate electrodes GE11...GE1n and GE21...GE2n described using FIG. 10 and an insulating layer 115 therebetween.

Referring to FIG. 10, the third gate electrode GE25 is connected to the third gate contact GC11 through the third pad portion PD11. The fifth gate electrode GE24 is connected to the fifth gate contact GC12 through the fifth pad portion PD12. The first gate electrode GE23 is connected to the first gate contact GC13 through the first pad portion PD13.

The first capacitor C1 includes the third gate electrode GE25, the fifth gate electrode GE24, and the insulating layer 115 therebetween. The third gate electrode GE25 and the fifth gate electrode GE24 may constitute the capacitor electrode of the first capacitor C1, and the insulating layer 115 may constitute a capacitor dielectric.

The second capacitor C2 includes the fifth gate electrode GE24, the first gate electrode GE23, and the insulating layer 115 therebetween. The fifth gate electrode GE24 and the first gate electrode GE23 may constitute a capacitor electrode of the second capacitor C2, and the insulating layer 115 may constitute a capacitor dielectric.

Referring to FIGS. 10 and 11, the first capacitor C1 and the second capacitor C2 may be connected in parallel.

In some embodiments, the gate electrodes of the dummy cell block region DBR may be used as capacitor electrodes. Accordingly, it is possible to further ensure the capacitance of the semiconductor memory device.

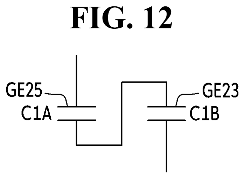

FIG. 12 is an example diagram for explaining a capacitor structure of the semiconductor memory device according to some embodiments. For convenience of explanation, repeated parts of contents explained above using FIGS. 1 to 11 will be briefly explained or omitted.

Referring to FIG. 12, a first capacitor C1A and a second capacitor C1B may be connected in series. In this case, the fifth gate contact GC12 may be electrically floating, unlike FIG. 10.

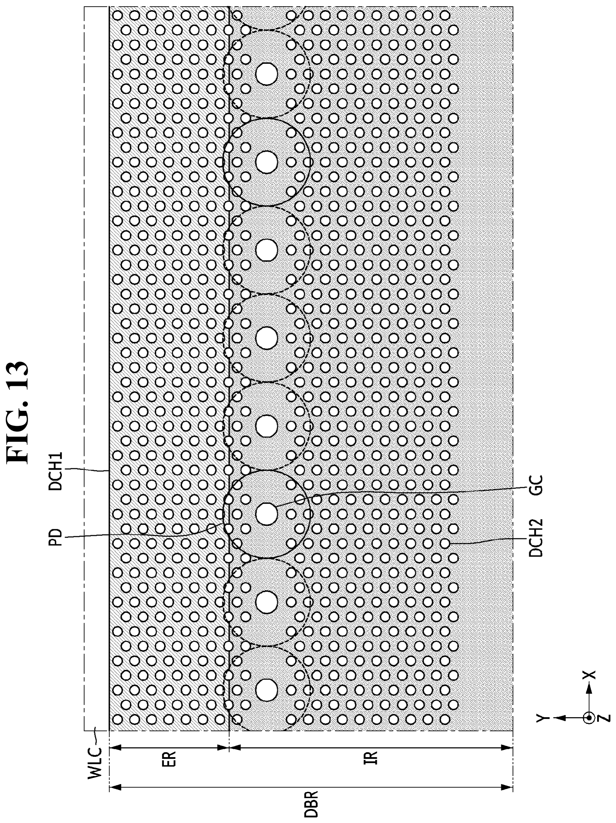

FIGS. 13 to 22 are example diagrams for explaining a semiconductor memory device according to some embodiments. For convenience of explanation, repeated parts of contents explained above using FIGS. 1 to 12 will be briefly explained or omitted.

Referring to FIG. 13, a plurality of second dummy channel structures DCH2 may be further disposed in the mold region IR. The second dummy channel structures DCH2 may be spaced apart from the first dummy channel structures DCH1 in the second direction Y with the pad portion PD interposed therebetween.

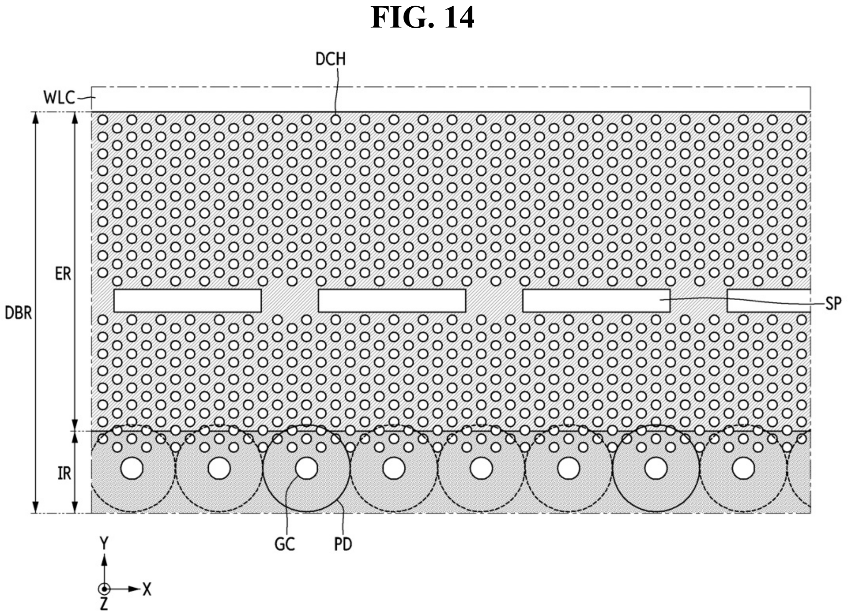

Referring to FIG. 14, a plurality of separation patterns SP may be further disposed in the electrode region ER. The plurality of separation patterns SP may be spaced apart from one another in the first direction X. The plurality of separation patterns SP may be spaced apart from the separation structure WLC in the second direction Y. The dummy channel structures DCH may be spaced apart from one another in the second direction Y with the separation patterns SP interposed therebetween. The width of the separation patterns SP in the first direction X may be equal to, but is not limited to, the width of the separation structure WLC in the first direction X. The separation patterns SP may include the same insulating material as the separation structure WLC.

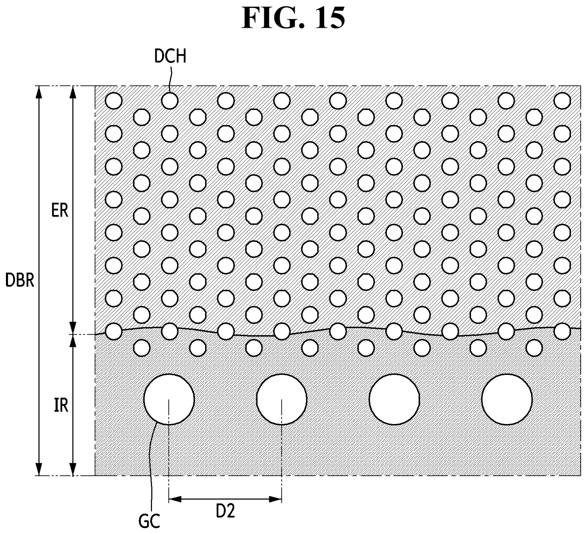

Referring to FIG. 15, from a planar viewpoint, the gate contacts GC may have a second pitch D2. The second pitch D2 may be smaller than the first pitch D1 of FIG. 5.

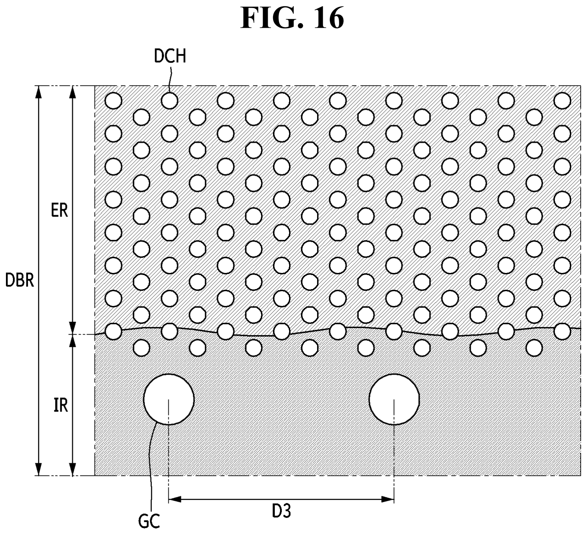

Referring to FIG. 16, the gate contacts GC may have a third pitch D3 from a planar viewpoint.

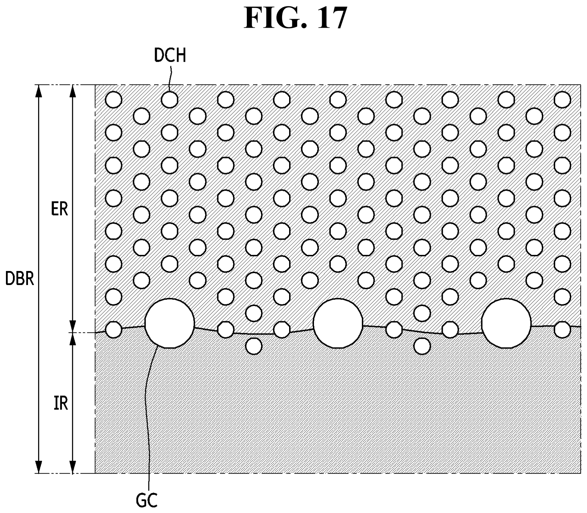

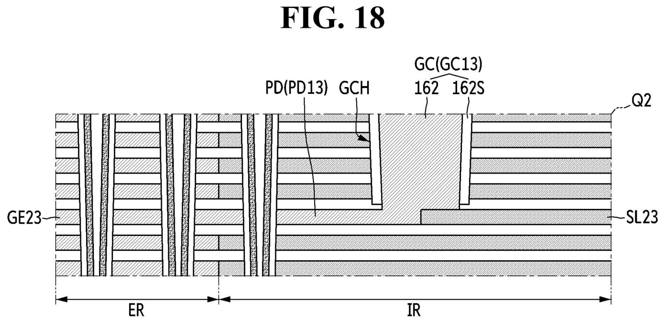

Referring to FIGS. 17 and 18, a part of the lower side of the contact conductive layer 162 may be in contact with the first pad portion PD13. For example, the lower side of the contact conductive layer 162 may include a first portion that is in contact with the first pad portion PD13, and a second portion that is in contact with the insulating layer SL23.

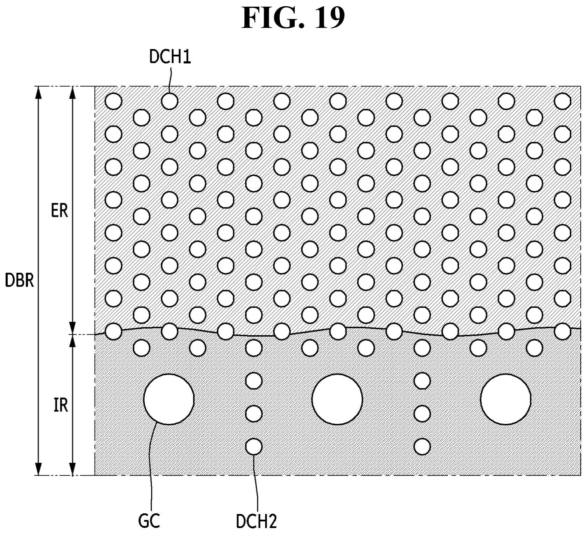

Referring to FIG. 19, a first dummy channel structure DCH1 may be disposed in the electrode region ER, and a second dummy channel structure DCH2 may be further disposed in the mold region IR. The second dummy channel structure DCH2 may be spaced apart from the gate contact GC in the first direction X. The second dummy channel structure DCH2 may be disposed between the gate contacts GC in the first direction X. A plurality of second dummy channel structures DCH2 may be disposed in the region between the gate contacts GC in the second direction Y.

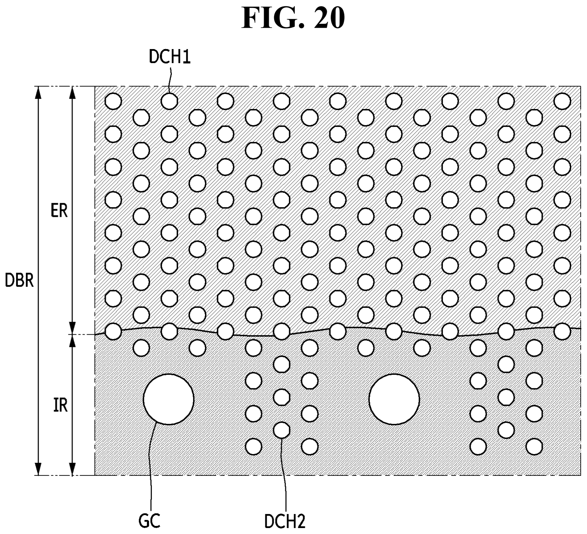

Referring to FIG. 20, a plurality of second dummy channel structure DCH2 may be disposed between the gate contacts GC in the first direction X.

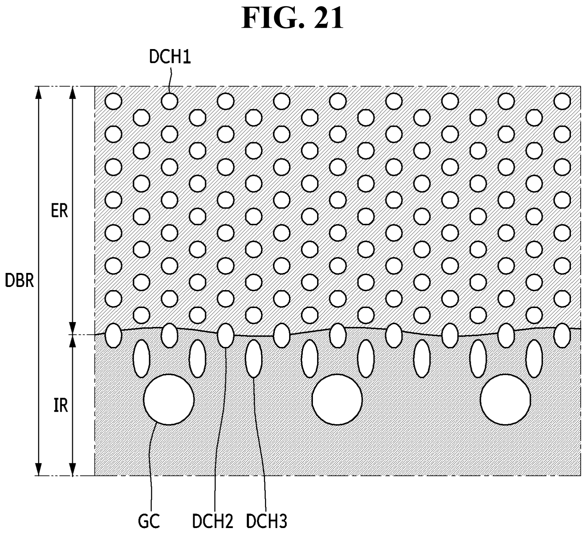

Referring to FIG. 21, the second dummy channel structure DCH2 may overlap each of the electrode region ER and the mold region IR. A third dummy channel structure DCH3 may be disposed in the mold region IR. The first dummy channel structure DCH1, the second dummy channel structure DCH2, and the third dummy channel structure DCH3 may have different sizes from one another. A size of the second dummy channel structure DCH2 may be larger than a size of the first dummy channel structure DCH1. A length of the second dummy channel structure DCH2 in the second direction Y may be longer than a length of the first dummy channel structure DCH1 in the second direction Y. A size of the third dummy channel structure DCH3 may be larger than the size of the second dummy channel structure DCH2. A length of the third dummy channel structure DCH3 in the second direction Y may be longer than the length of the second dummy channel structure DCH2 in the second direction Y.

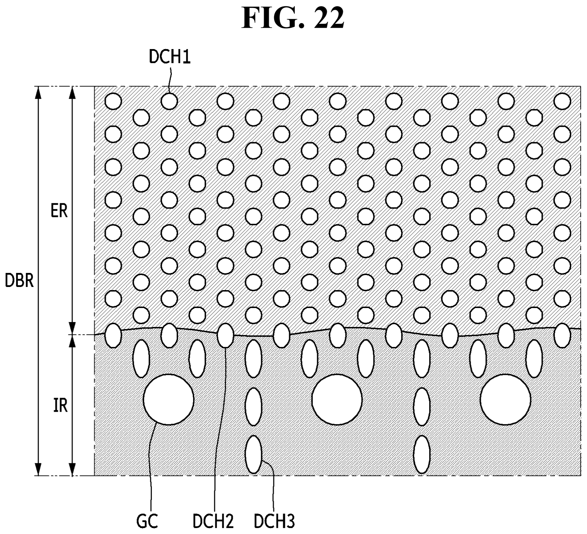

Referring to FIG. 22, the third dummy channel structure DCH3 may be spaced apart from the gate contact GC in the first direction X. The third dummy channel structure DCH3 may be disposed between the gate contacts GC in the first direction X. A plurality of third dummy channel structures DCH3 may be disposed in the region between the gate contacts GC in the second direction Y. The size of the third dummy channel structure DCH3 may be larger than the sizes of each of the first dummy channel structure DCH1 and the second dummy channel structure DCH2.

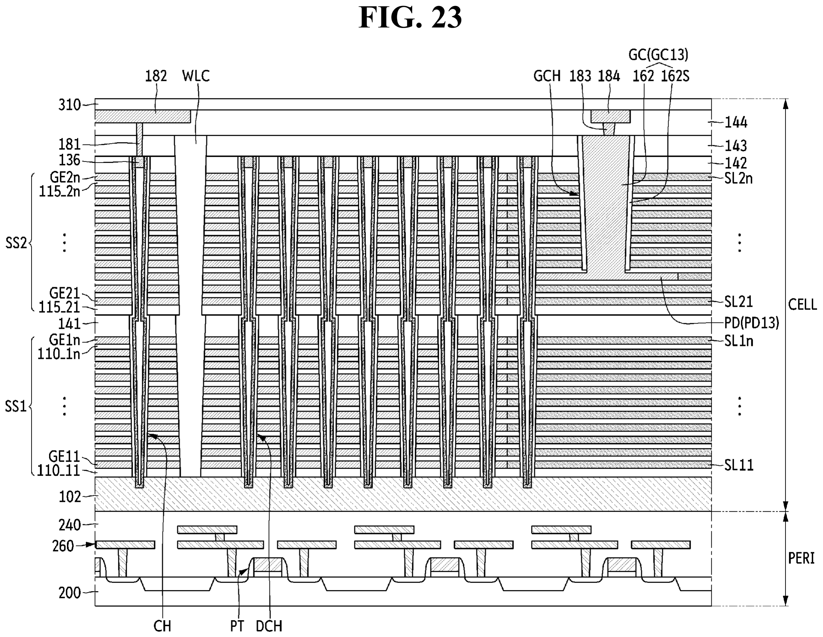

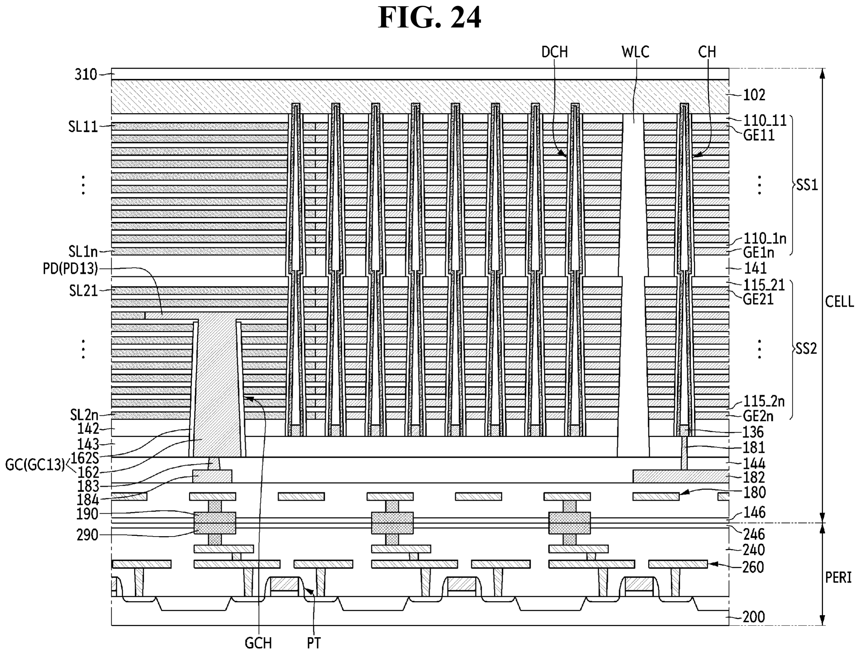

FIGS. 23 and 24 are example cross-sectional views for explaining a semiconductor memory device according to some embodiments. For convenience of explanation, repeated parts of contents explained above using FIGS. 1 to 22 will be briefly explained or omitted.

Referring to FIGS. 23 and 24, the semiconductor memory device according to some embodiments may include a memory cell region CELL and a peripheral circuit region PERI.

Referring to FIG. 23, the memory cell region CELL may include a substrate 102, a gate stack structure GST, a mold structure MST, a channel structure CH, a bit line 182, a dummy channel structure DCH, a separation structure WLC, a gate contact GC, and a first inter-wiring insulating film 310.

The peripheral circuit region PERI may include a peripheral circuit board 200, a peripheral circuit element PT, and a wiring structure 260.

The peripheral circuit board 200 may include a semiconductor substrate, for example, such as a silicon substrate, a germanium substrate or a silicon-germanium substrate. Alternatively, the peripheral circuit board 200 may include a silicon-on-insulator (SOI) substrate, a germanium-on-insulator (GOI) substrate, or the like.

The peripheral circuit element PT may be formed on the upper side of the peripheral circuit board 200. The peripheral circuit element PT may constitute a peripheral circuit (e.g., 30 of FIG. 1) that controls the operation of the semiconductor memory device. For example, the peripheral circuit element PT may include the control logic (e.g., 37 of FIG. 1), the row decoder (e.g., 33 of FIG. 1), the page buffer (e.g., 35 of FIG. 1), and the like. In the following description, a surface of the peripheral circuit board 200 on which the peripheral circuit element PT is disposed may be referred to as a front side of the peripheral circuit board 200. In contrast, a surface of the peripheral circuit board 200 opposite to the front side of the peripheral circuit board 200 may be referred to as a back side of the peripheral circuit board 200.

The peripheral circuit element PT may include, for example, but is not limited to, a transistor. For example, the peripheral circuit element PT may include not only various active elements such as a transistor, but also various passive elements such as a capacitor, a resistor, and an inductor.

In the semiconductor memory device according to some embodiments, the back side of the substrate 102 may be opposite to the front side of the peripheral circuit board 200. For example, a second inter-wiring insulating film 240 that covers the peripheral circuit element PT may be formed on the upper side of the peripheral circuit board 200. The substrate 102 may be stacked on the upper side of the second inter-wiring insulating film 240.

A wiring structure 260 connected to the peripheral circuit element PT may be formed inside the second inter-wiring insulating film 240. The wiring structure 260 may include a conductive material, for example, but is not limited to, at least one of aluminum (Al), copper (Cu), tungsten (W), molybdenum (Mo), cobalt (Co), ruthenium (Ru), and alloys thereof. As an example, the wiring structure 260 may include a copper (Cu) wiring.

Referring to FIG. 24, in the semiconductor memory device according to some embodiments, the upper side of the substrate 102 is opposite to the front side of the peripheral circuit board 200.

For example, the semiconductor memory device according to some embodiments may have a C2C (chip to chip) structure. The C2C structure may mean a structure in which an upper chip including a memory cell region CELL is fabricated on a first wafer (e.g., the substrate 102) and a lower chip including the peripheral circuit region PERI is fabricated on a second wafer (e.g., the peripheral circuit board 200) different from the first wafer, and then, the upper chip and the lower chip are connected to one another by a bonding way.

As an example, the bonding way may mean a way of connecting the first bonding metal 190 (and/or the first bonding insulating film 146) formed on the uppermost metal layer of the upper chip and the second bonding metal 290 (and/or the second bonding insulating film 246) formed on the uppermost metal layer of the lower chip to one another. For example, when the first bonding metal 190 and the second bonding metal 290 are formed of copper (Cu), the bonding way may be a Cu-Cu bonding way. However, this is merely an example, and the first bonding metal 190 and the second bonding metal 290 may, of course, be formed of various other metals such as aluminum (Al) or tungsten (W).

As the first bonding metal 190 and the second bonding metal 290 are bonded, the first wiring structure 180 may be electrically connected to the second wiring structure 260. Accordingly, the plurality of memory cells of the memory cell region CELL may be electrically connected to the peripheral circuit element PT.

The first wiring structure 180 may be formed on a fourth interlayer insulating film 144. The first wiring structure 180 may provide an electrical path for the operation of each memory cell. The first wiring structure 180 is formed on the fourth interlayer insulating film 144, and may be connected to the substrate 102, the channel structure CH, and/or the gate contact GC. The number of layers and the arrangement of the first wiring structure 180 are merely examples, and are not limited to those shown in the drawings.

The first wiring structure 180 may include conductive materials, for example, but are not limited to, at least one of aluminum (Al), copper (Cu), tungsten (W), molybdenum (Mo), cobalt (Co), ruthenium (Ru), and alloys thereof. As an example, the first wiring structure 180 may include a copper (Cu) wiring.

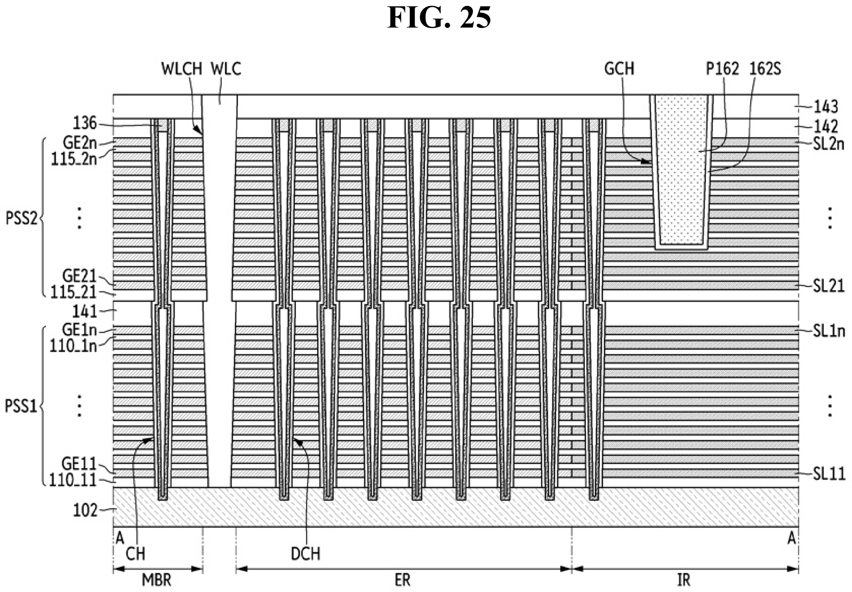

FIGS. 25 to 29 are intermediate diagrams for explaining a method for fabricating a semiconductor memory device according to some embodiments. For convenience of explanation, repeated parts of contents explained above using FIGS. 1 to 24 will be briefly explained or omitted.

Referring to FIG. 25, the substrate 102 including the memory cell block region MBR and the dummy cell block region DBR is provided. The dummy cell block region DBR may include an electrode region ER and a mold region IR.

A first pre-stack structure (not shown) which includes first insulating layers 110_11...115_2n and sacrificial layers SL11...SL2n alternately stacked may be formed on the substrate 102. The first insulating layers 110_11...115_2n and the sacrificial layers SL11...SL2n of the first pre-stack structure (not shown) are formed in the memory cell block region MBR and the dummy cell block region DBR.

A channel structure CH which penetrates the first pre-stack structure (not shown) is formed in the memory cell block region MBR, and a dummy channel structure DCH may be formed in the electrode region ER.

The sacrificial layers SL11...SL2n of the first pre-stack structure (not shown) are removed, and second_1 and second_2 pre-stack structures PSS1 and PSS2 including first insulating layers 110_11...115_2n and gate electrodes GE11...GE2n alternately stacked with one another may be formed in the memory cell block region MBR.

In the memory cell block region MBR, a separation structure WLC may be formed in a separation structure hole WLCH that penetrates the first pre-stack structure (not shown).

A pre-mold structure which includes first insulating layers 110_11...115_2n and third insulating layers SL11...SL2n alternately stacked with one another may be formed in the mold region IR. The third insulating layers SL11...SL2n of the mold region IR may refer to sacrificial layers that remain without being completely removed in the removal process of the sacrificial layers SL11...SL2n of the first pre-stack structure (not shown) described above.

After that, the gate contact hole GCH that penetrates at least a part of the pre-mold structure may be formed in the mold region IR. A contact insulating layer 162S and a sacrificial insulating layer P162 may be formed inside the gate contact hole GCH. The contact insulating layer 162S may be conformally formed along the side wall and bottom side of the gate contact hole GCH. The sacrificial insulating layer P162 may fill the remaining inside of the gate contact hole GCH after the contact insulating layer 162S is formed.

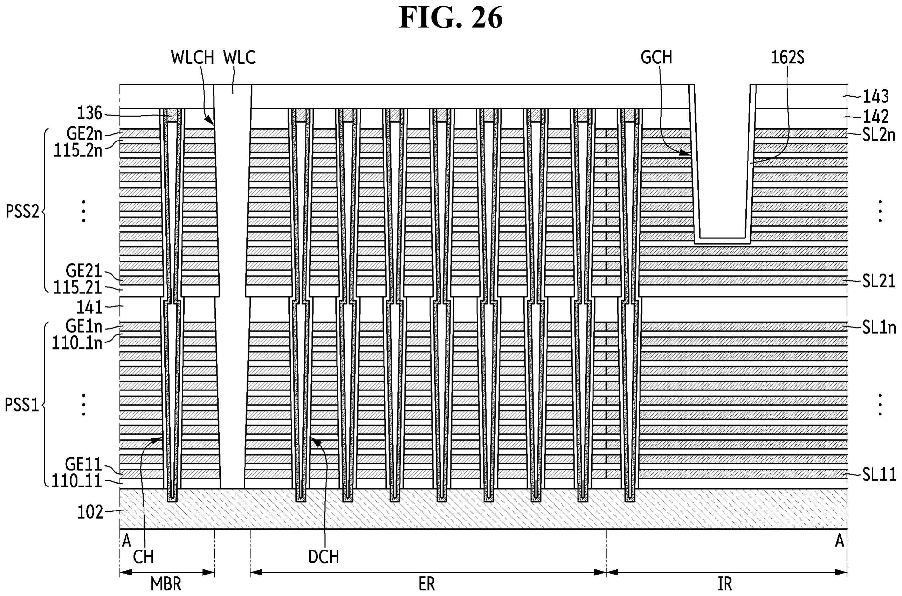

Referring to FIG. 26, the sacrificial insulating layer P162 of the mold region IR may be removed. As the sacrificial insulating layer P162 is removed, the contact insulating layer 162S may be exposed.

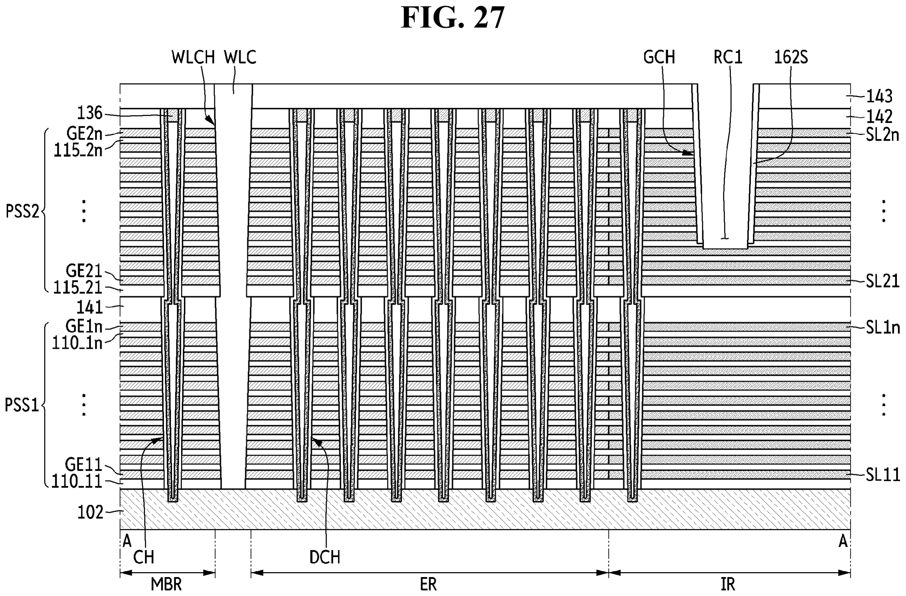

Referring to FIG. 27, a first recess RC1 that exposes any one (e.g., SL23 of FIG. 8) of the third insulating layers SL11...SL2n may be formed in the mold region IR. The first recess RC1 may be formed by removing a part of one of the first insulating layers 110_11...115_2n, for example, by an etch-back process.

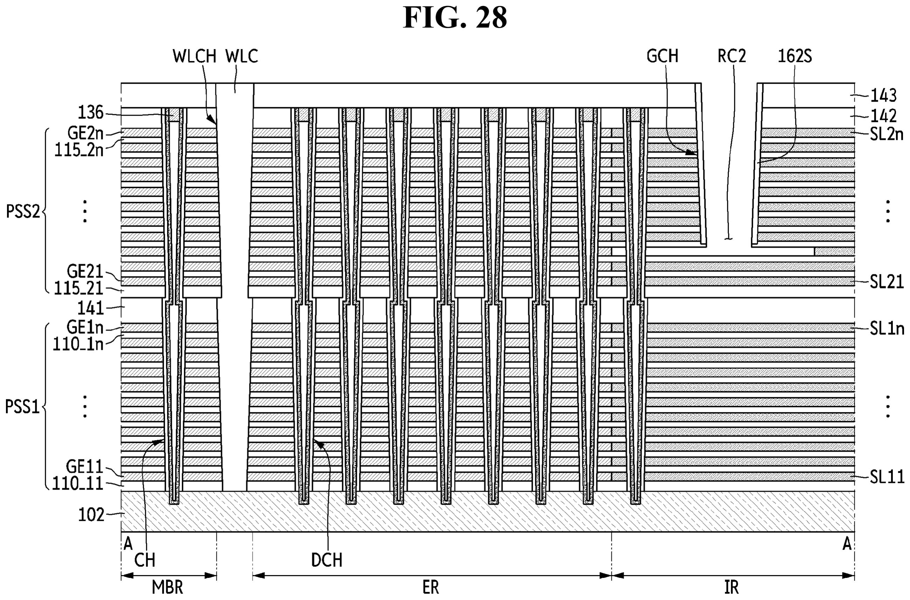

Referring to FIG. 28, at least a part of one (e.g., SL23 of FIG. 8) of the third insulating layers SL11...SL2n may be removed, using the first recess RC1. That is, a second recess RC2 that extends in the horizontal direction may be formed in one (e.g., SL23 of FIG. 8) of the third insulating layers SL11...SL2n. Accordingly, the second recess RC2 may be formed in the mold region IR adjacent to one (e.g., GE23 of FIG. 8) of the gate electrodes GE11...GE1n and GE21...GE2n.

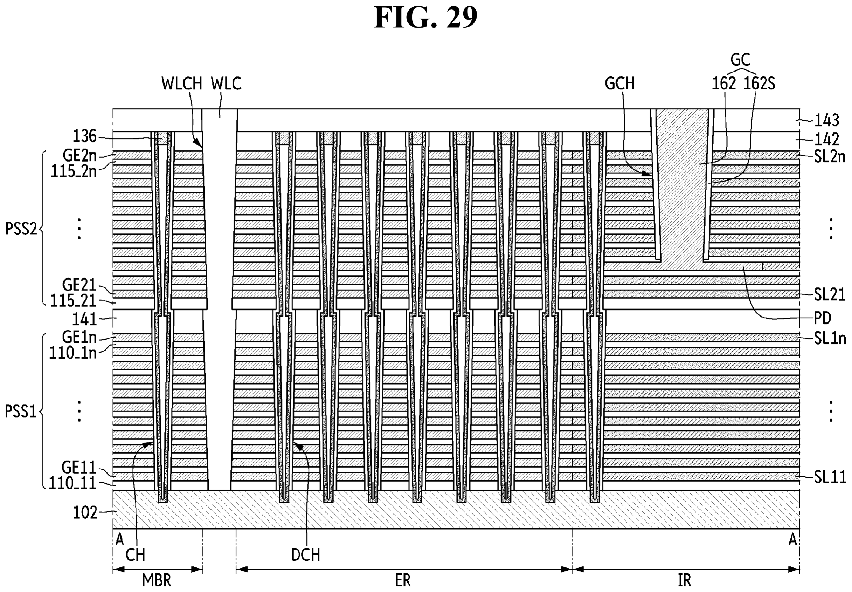

Referring to FIG. 29, the pad portion PD and the contact conductive layer 162 that fill the second recess RC2 may be formed. Accordingly, the gate contact GC connected to any one (e.g., GE23 of FIG. 8) of the gate electrodes GE11...GE1n and GE21...GE2n may be formed. The pad portion PD and the contact conductive layer 162 may be formed in the same process.

After that, the first contact pattern (181 of FIG. 6) and the first conductive line (182 of FIG. 6) connected to the channel structure CH may be formed. The second contact pattern (183 of FIG. 6) and the second conductive line (184 of FIG. 6) connected to the gate contact GC may be formed.

The semiconductor memory device described using FIGS. 1 to 11 may be fabricated by such a process.

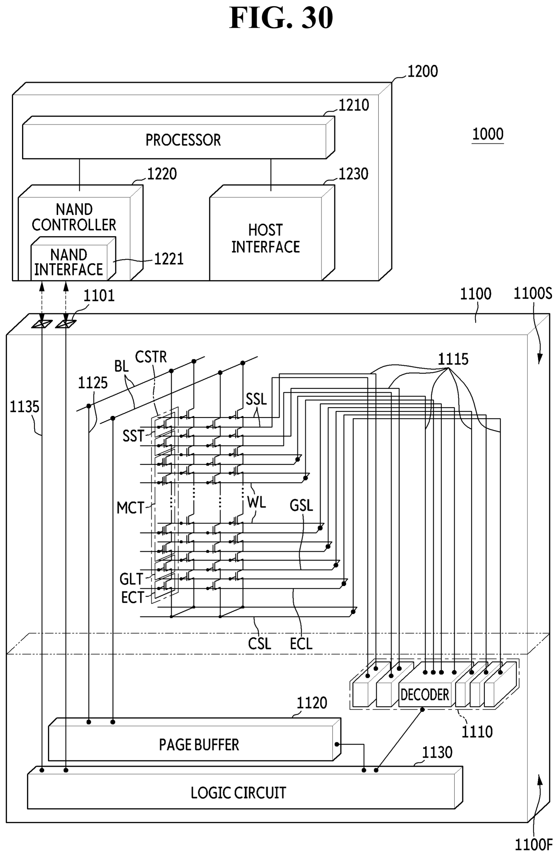

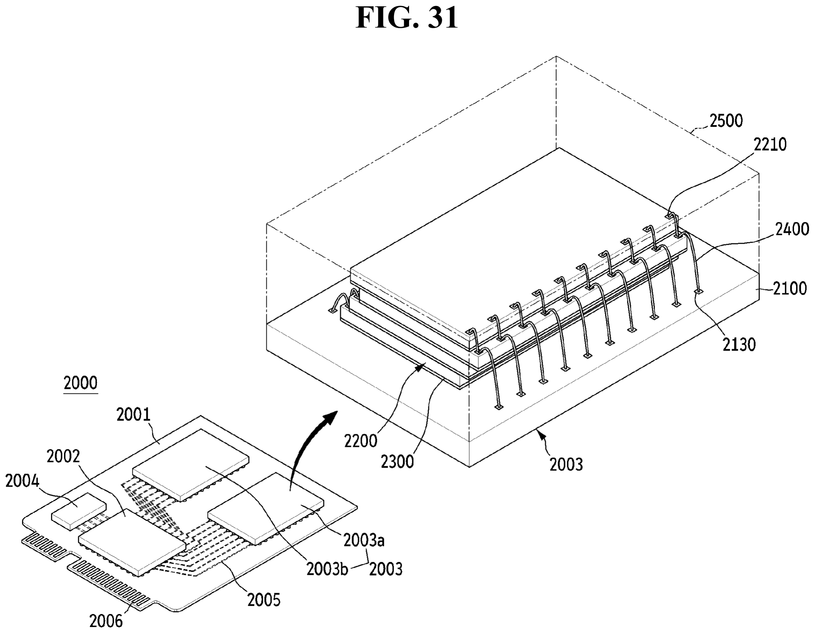

FIG. 30 is an example block diagram for explaining an electronic system according to some embodiments. FIG. 31 is an example perspective view for explaining the electronic system according to some embodiments. For convenience of explanation, repeated parts of contents explained above using FIGS. 1 to 29 will be briefly explained or omitted.

Referring to FIG. 30, an electronic system 1000 according to some embodiments may include a non-volatile memory device 1100, and a controller 1200 electrically connected to the non-volatile memory device 1100. The electronic system 1000 may be a storage device that includes one or multiple non-volatile memory devices 1100, or an electronic device that includes the storage device. For example, the electronic system 1000 may be an SSD device (solid state drive device), a USB (Universal Serial Bus), a computing system, a medical device or a communication device that includes one or multiple non-volatile memory devices 1100.

The non-volatile memory device 1100 may be, for example, a NAND flash memory device, and may be, for example, the semiconductor memory device explained above using FIG. 1 to 29. The non-volatile memory device 1100 may include a first structure 1100F, and a second structure 1100S on the first structure 1100F.

The first structure 1100F may be a peripheral circuit structure that includes a decoder circuit 1110 (e.g., a row decoder 33 of FIG. 1), a page buffer 1120 (e.g., the page buffer 35 of FIG. 1), and a logic circuit 1130 (e.g., the control logic 37 of FIG. 1).

The second structure 1100S may include the common source line CSL, the plurality of bit lines BL, and the plurality of cell strings CSTR explained above using FIGS. 1 and 2. The cell strings CSTR may be connected to the decoder circuit 1110 through the word line WL, at least one string selection line SSL, and at least one ground selection line GSL. Additionally, the cell strings CSTR may be connected to the page buffer 1120 through the bit lines BL.

In some embodiments, the common source line CSL and the cell strings CSTR may be electrically connected to the decoder circuit 1110 through first connection wirings 1115 that extend from the first structure 1100F to the second structure 1100S.

In some embodiments, the bit lines BL may be electrically connected to the page buffer 1120 through second connection wirings 1125 that extend from the first structure 1100F to the second structure 1100S.

The non-volatile memory device 1100 may communicate with the controller 1200 through an I/O pad 1101 that is electrically connected to the logic circuit 1130 (e.g., the control logic 37 of FIG. 1). The I/O pad 1101 may be electrically connected to the logic circuit 1130 through an I/O connection wiring 1135 that extends from the inside of the first structure 1100F to the second structure 1100S.

The controller 1200 may include a processor 1210, a NAND controller 1220, and a host interface 1230. In some embodiments, the electronic system 1000 may include a plurality of non-volatile memory devices 1100, and in this case, the controller 1200 may control the plurality of non-volatile memory devices 1100.

The processor 1210 may control the overall operation of the electronic system 1000, including the controller 1200. The processor 1210 may operate according to a predetermined firmware, and may control the NAND controller 1220 to access the non-volatile memory device 1100. The NAND controller 1220 may include a NAND interface 1221 that processes communication with the non-volatile memory device 1100. Control command for controlling the non-volatile memory device 1100, data to be recorded in the memory cell transistors MCT of the non-volatile memory device 1100, data to be read from the memory cell transistors MCT of the non-volatile memory device 1100, and the like may be transmitted through the NAND interface 1221. The host interface 1230 may provide a communication function between the electronic system 1000 and an external host. When the control command is received from the external host through the host interface 1230, the processor 1210 may control the non-volatile memory device 1100 in response to the control command.

Referring to FIGS. 30 and 31, the electronic system according to some embodiments may include a main board 2001, a main controller 2002 mounted on the main board 2001, one or more semiconductor packages 2003, and a DRAM 2004. The semiconductor package 2003 and the DRAM 2004 may be connected to the main controller 2002 by wiring patterns 2005 formed on the main board 2001.

The main board 2001 may include a connector 2006 including a plurality of pins coupled to an external host. In the connector 2006, the number and placement of the plurality of pins may vary depending on the communication interface between the electronic system 2000 and the external host. In some embodiments, the electronic system 2000 may communicate with the external host according to any one of interfaces such as M-Phy for a USB (Universal Serial Bus), a PCI-Express (Peripheral Component Interconnect Express), a SATA (Serial Advanced Technology Attachment), and a UFS (Universal Flash Storage). In some embodiments, the electronic system 2000 may operate by power supplied from the external host through the connector 2006. The electronic system 2000 may further include a PMIC (Power Management Integrated Circuit) that distributes the power supplied from the external host to the main controller 2002 and the semiconductor package 2003.

The main controller 2002 may record data in the semiconductor package 2003 or read data from the semiconductor package 2003, and may improve the operating speed of the electronic system 2000.

The DRAM 2004 may be a buffer memory for relieving a speed difference between the semiconductor package 2003, which is a data storage space, and the external host. The DRAM 2004 included in the electronic system 2000 may also operate as a kind of cache memory, and may also provide a space for temporarily storing data in the control operation on the semiconductor package 2003. When the DRAM 2004 is included in the electronic system 2000, the main controller 2002 may further include a DRAM controller for controlling the DRAM 2004, in addition to a NAND controller for controlling the semiconductor package 2003.

The semiconductor package 2003 may include a first semiconductor package 2003a and a second semiconductor package 2003b that are spaced apart from one another. Each of the first semiconductor package 2003a and the second semiconductor package 2003b may be a semiconductor package that includes a plurality of semiconductor chips 2200. Each of the first semiconductor package 2003a and the second semiconductor package 2003b may include a package substrate 2100, semiconductor chips 2200 on the package substrate 2100, adhesive layers 2300 disposed on the lower sides of each of the semiconductor chips 2200, a connecting structure 2400 that electrically connects the semiconductor chips 2200 and the package substrate 2100, and a molding layer 2500 that covers the semiconductor chips 2200 and the connecting structure 2400 on the package substrate 2100.

The package substrate 2100 may be a printed circuit board that includes package upper pads 2130. Each semiconductor chip 2200 may include an I/O pad 2210. The I/O pad 2210 may correspond to the I/O pad 1101 of FIG. 30.

In some embodiments, the connecting structure 2400 may be a bonding wire that electrically connects the I/O pad 2101 and the package upper pads 2130. Therefore, in each of the first semiconductor package 2003a and the second semiconductor package 2003b, the semiconductor chips 2200 may be electrically connected to one another in a bonding wire manner, and may be electrically connected to the package upper pads 2130 of the package substrate 2100. In some embodiments, in each of the first semiconductor package 2003a and the second semiconductor package 2003b, the semiconductor chips 2200 may be electrically connected to one another by a connecting structure including a through electrode (Through Silicon Via, TSV), instead of the connecting structure 2400 of a bonding wire type.

In some embodiments, the main controller 2002 and the semiconductor chips 2200 may also be included in a single package. In some embodiments, the main controller 2002 and the semiconductor chips 2200 are mounted on a separate interposer substrate different from the main board 2001, and the main controller 2002 and the semiconductor chips 2200 may also be connected to one another by the wiring formed on the interposer substrate.

In the electronic system according to some embodiments, each of the semiconductor chips 2200 may include the semiconductor memory device explained above using FIGS. 1 to 29. For example, each of the semiconductor chips 2200 may include a peripheral circuit region PERI and a memory cell region CELL. As an example, the memory cell region CELL may include the substrate 102, the gate stack structure GST, the channel structure CH, the dummy channel structure DCH, the mold structure MST, and the gate contact GC explained above using FIGS. 1 to 29.

The substrate 102 may include a memory cell block region MBR and a dummy cell block region DBR. The dummy cell block region DBR may include an electrode region ER and a mold region IR. In the memory cell block region MBR and the electrode region ER, the gate stack structure GST may include first insulating layers 110_11...115_2n and gate electrodes GE11...GE2n that are alternately stacked with one another. In the memory cell block region MBR, the channel structure CH may penetrate the gate stack structure GST. In the electrode region ER, the dummy channel structure DCH may penetrate the gate stack structure GST. In the mold region IR, the mold structure MST may include first insulating layers 110_11...115_2n and third insulating layers SL11...SL2n that are alternately stacked with one another, and a pad portion PD. The pad portion PD may be disposed in a specific insulating layer among the third insulating layers SL11...SL2n. The pad portion PD may be connected to a specific gate electrode among the gate electrodes GE11...GE2n. The gate contact GC penetrates at least a part of the mold structure MST, and may be connected to the pad portion PD. The gate contact GC may be connected to a specific gate electrode among the gate electrodes GE11...GE2n through the pad portion PD.
Embodiments are set out in the following clauses:
Clause 1. A semiconductor memory device comprising: a substrate which extends in a first direction and a second direction that intersect one another, and includes a first region, and a second region spaced apart from the first region in the first direction around the first region; a gate stack structure which includes first insulating layers and gate electrode layers alternately stacked with one another, in the first region; a channel structure which penetrates the gate stack structure; a mold structure which includes first insulating layers and second insulating layers alternately stacked with one another and having different materials from one another in the second region, each of the second insulating layers extending from each of the gate electrode layers in a horizontal direction; a separation structure which separates the first region and the second region in the first direction, and extends in the second direction; and a first gate contact which penetrates at least a part of the mold structure, and is connected to a first gate electrode layer among the gate electrode layers.
Clause 2. The semiconductor memory device of Clause 1, wherein the first gate contact includes a first gate contact hole extending into the mold structure, and a contact insulating layer and a contact conductive layer inside the first gate contact hole.
Clause 3 The semiconductor memory device of Clause 2, wherein an entire lower side of the contact conductive layer is in contact with the first gate electrode layer.
Clause 4. The semiconductor memory device of Clause 2 or 3, wherein a part of the lower side of the contact conductive layer is in contact with the first gate electrode layer.
Clause 5. The semiconductor memory device of Clause 2, 3 or 4, wherein the first gate electrode layer includes a material different from that of the contact conductive layer.
Clause 6. The semiconductor memory device of any preceding Clause, further comprising: a second gate contact which is spaced apart from the first gate contact, penetrates at least a part of the mold structure, and is connected to the first gate electrode layer.
Clause 7. The semiconductor memory device of any preceding Clause, wherein the separation structure is disposed between the channel structure and the first gate contact.
Clause 8. The semiconductor memory device of any preceding Clause, further comprising: a dummy gate stack structure which includes the first insulating layers and dummy gate electrode layers that are alternately stacked between the first region and the second region; and a dummy channel structure which penetrates the dummy gate stack structure.
Clause 9. The semiconductor memory device of Clause 8, wherein the dummy channel structure includes the same material as a material of the channel structure.
Clause 10. The semiconductor memory device of any preceding Clause, further comprising: a peripheral circuit region electrically connected to the first region, on the substrate.
Clause 11. The semiconductor memory device of any preceding Clause, wherein each of the gate electrode layers includes tungsten, each of the first insulating layers includes silicon oxide, and each of the second insulating layers includes silicon nitride.
Clause 12. A semiconductor memory device comprising: a substrate which extends in a first direction and a second direction that intersect one another, and includes a first region, a second region, and a third region that are different from one another, the second region being spaced apart from the first region in the first direction; a gate stack structure which includes first insulating layers and gate electrode layers alternately stacked with one another in the first region; a channel structure which penetrates the gate stack structure; a bit line which is connected to the channel structure, and extends in the first direction; a dummy gate stack structure which includes second insulating layers and dummy gate electrode layers that are alternately stacked with one another, in the second region; a first dummy channel structure which penetrates the dummy gate stack structure; a separation structure which separates the first region and the second region in the first direction, and extends in the second direction between the channel structure and the first dummy channel structure; a mold structure which includes third insulating layers and fourth insulating layers alternately stacked with one another and having different materials from one another in the third region, and further includes a first pad portion that connects one of the third insulating layers and one of the gate electrode layers; and a first gate contact which penetrates at least a part of the mold structure and is connected to the first pad portion.
Clause 13. The semiconductor memory device of Clause 12, wherein a width of the first pad portion is greater than a width of the first gate contact.
Clause 14. The semiconductor memory device of Clause 12 or 13, wherein the mold structure further includes a second pad portion that connects one of the third insulating layers and one of the gate electrode layers, and is spaced apart from the first pad portion; and a second gate contact which penetrates at least a part of the mold structure, and is connected to the second pad portion.
Clause 15. The semiconductor memory device of Clause 12, 13 or 14, further comprising: a second dummy channel structure which is spaced apart from the first dummy channel structure in the first direction with the first pad portion interposed between them, in the third region.
Clause 16. The semiconductor memory device of any one of Clauses 12 to 15, further comprising: a plurality of separation patterns that are spaced apart from the separation structure in the first direction, in the second region.
Clause 17. The semiconductor memory device of any one of Clauses 12 to 16, further comprising: a second dummy channel structure which is spaced apart from the first gate contact in the second direction, in the third region.
Clause 18. The semiconductor memory device of any one of Clauses 12 to 17, further comprising: a second dummy channel structure which overlaps each of the second region and the third region, and has a different size from a size of the first dummy channel structure.
Clause 19. The semiconductor memory device of any one of Clauses 12 to 18, further comprising: a second dummy channel structure which is spaced apart from the first gate contact in the second direction, and has a different size from a size of the first dummy channel structure, in the third region.
Clause 20. An electronic system comprising: a main board; a semiconductor memory device on the main board; and a controller electrically connected to the semiconductor memory device, on the main board, wherein the semiconductor memory device includes: a substrate which extends in each of a first direction and a second direction that intersect one another, and includes a first region, a second region, and a third region that are different from one another, the second region being spaced apart from the first region in the first direction; a gate stack structure which includes first insulating layers and gate electrode layers alternately stacked with one another, in the first region; a channel structure which penetrates the gate stack structure; a dummy gate stack structure which includes second insulating layers and dummy gate electrode layers that are alternately stacked with one another, in the second region; a dummy channel structure which penetrates the dummy gate stack structure; a separation structure which separates the first region and the second region in the first direction, and extends in the second direction; a mold structure which includes third insulating layers and fourth insulating layers having different materials from one another and alternately stacked with one another, and a pad portion connected to one of the third insulating layers and one of the gate electrode layers, in the third region; and a gate contact which penetrates at least a part of the mold structure and is connected to the first pad portion.

Although the embodiments of the present disclosure have been explained above with reference to the accompanying drawings, the present disclosure is not limited to the above embodiments, and may be fabricated in various different forms. Those skilled in the art will appreciate that the present disclosure may be embodied in other specific forms without changing the essential features of the present disclosure, which are defined in the appended claims. Accordingly, the above-described embodiments should be understood in all respects as illustrative and not restrictive.

## Claims

1. A semiconductor memory device comprising:
a substrate (102) which extends in a first direction (X) and a second direction (Y) that intersect one another, and includes a first region (MBR), and a second region (DBR) spaced apart from the first region (MBR) in the second direction (Y) around the first region (MBR);
a gate stack structure (GST) which includes first insulating layers (110_11...110_1n) and gate electrode layers (GE11...GE1n) alternately stacked with one another, in the first region (MBR);
a channel structure (CH) which penetrates the gate stack structure (GST);
a mold structure (MS1) which includes the first insulating layers (110_11...110_1n) and second insulating layers (SL11...SL1n) alternately stacked with one another and having different materials from one another in the second region (DBR), each of the second insulating layers (SL11...SL1n) extending from each of the gate electrode layers (GE11...GE1n) in the second direction (Y);
a separation structure (WLC) which separates the first region (MBR) and the second region (DBR) in the first direction (X), and extends in the second direction (Y); and
a first gate contact (GC13) which penetrates at least a part of the mold structure (MS1), and is connected to a first gate electrode layer (GE23) among the gate electrode layers (GE11...GE1n).

2. The semiconductor memory device of claim 1,
wherein the first gate contact (GC13) includes a first gate contact hole (GCH) extending into the mold structure (MS1), and a contact insulating layer (162S) and a contact conductive layer (162) inside the first gate contact hole (GCH).

3. The semiconductor memory device of claim 2,
wherein an entire lower side of the contact conductive layer (162) is in contact with the first gate electrode layer (GE23).

4. The semiconductor memory device of claim 2 or 3,
wherein a part of the lower side of the contact conductive layer (162) is in contact with the first gate electrode layer (GE23).

5. The semiconductor memory device of any one of claims 2, 3 or 4,
wherein the first gate electrode layer (GE23) includes a material different from that of the contact conductive layer (162).

6. The semiconductor memory device of any preceding claim, further comprising:
a second gate contact (GC23) which is spaced apart from the first gate contact (GC13), penetrates at least a part of the mold structure (MS1), and is connected to the first gate electrode layer (GE23).

7. The semiconductor memory device of any preceding claim,
wherein the separation structure (WLC) is disposed between the channel structure (CH) and the first gate contact (GC13).

8. The semiconductor memory device of any preceding claim, further comprising:
a dummy gate stack structure which includes the first insulating layers (110_11...110_1n) and dummy gate electrode layers that are alternately stacked between the first region (MBR) and the second region (DBR); and
a dummy channel structure (DCH) which penetrates the dummy gate stack structure.

9. The semiconductor memory device of claim 8,
wherein the dummy channel structure (DCH) includes the same material as a material of the channel structure (CH).

10. The semiconductor memory device of any preceding claim, further comprising:
a peripheral circuit region (PERI) electrically connected to the first region (MBR), on the substrate (102).

11. The semiconductor memory device of any preceding claim,
wherein each of the gate electrode layers (GE11...GE1n) includes tungsten,
each of the first insulating layers (110_11...110_1n) includes silicon oxide, and each of the second insulating layers (SL11...SL1n) includes silicon nitride.

12. The semiconductor memory device of claim 1, wherein:
the substrate (102) includes the first region (MBR), the second region (DBR(ER)), and a third region (DBR(IR)) that are different from one another;
the semiconductor device including:
a bit line (182) which is connected to the channel structure (CH), and extends in the first direction (X);
a dummy gate stack structure which includes second insulating layers and dummy gate electrode layers that are alternately stacked with one another, in the second region (DBR(ER));
a first dummy channel structure (DCH) which penetrates the dummy gate stack structure (SS1, SS2);
the separation structure (WLC) which extends in the second direction (Y) between the channel structure (CH) and the first dummy channel structure (DCH);
a mold structure (MS2) which includes third insulating layers (SL11...SL1n) and fourth insulating layers (115_21...115_2n) alternately stacked with one another and having different materials from one another in the third region (DBR/IR), and further includes a first pad portion (PD13) that connects one of the third insulating layers (SL11) and one of the gate electrode layers (GE11); and
the first gate contact (GC13) which penetrates at least a part of the mold structure (MS2) and is connected to the first pad portion (PD13).

13. The semiconductor memory device of claim 12,
wherein a width of the first pad portion (PD13) is greater than a width of the first gate contact (GC13).

14. The semiconductor memory device of claim 12 or 13,
wherein the mold structure further includes a second pad portion (PD23) that connects one of the third insulating layers (SL21...SL2n) and one of the gate electrode layers (GE11...GE1n), and is spaced apart from the first pad portion (PD13); and
a second gate contact (GC23) which penetrates at least a part of the mold structure, and is connected to the second pad portion (PD23).

15. The semiconductor memory device of any one of claims 12, 13 or 14, further comprising:
a second dummy channel structure (DCH2) which is spaced apart from the first dummy channel structure (DCH1) in the first direction (X) with the first pad portion (PD13) interposed between them, in the third region (DBR/IR).
